# EUROPEAN PATENT APPLICATION

(11) **EP 4 626 165 A1**
(43) Date of publication of application: **01.10.2025**
(21) Application number: 25156371.4
(22) Date of filing: 06.02.2025
(51) Int. Cl.: H10B 41/27, H10B 41/50, H10B 43/27, H10B 43/50

(54) **SEMICONDUCTOR DEVICES AND DATA STORAGE SYSTEMS INCLUDING THE SAME**

(30) Priority: 26.03.2024 KR 20240041381
(71) Applicant: Samsung Electronics Co., Ltd., Suwon-si, Gyeonggi-do 16677 (KR)
(72) Inventor: KOH, Beyounghyun, 16677 Suwon-si (KR); KIM, Hyunju, 16677 Suwon-si (KR); SIM, Jaehwang, 16677 Suwon-si (KR)
(74) Representative: Marks & Clerk LLP

(57) **Abstract**

A semiconductor device, comprising: a first semiconductor structure (PERI); and a second semiconductor structure (CELL) on the first semiconductor structure and having first (R1), second (R2), and third (R3) regions, wherein the second semiconductor structure includes: a plate (101); gate electrodes including a lower select gate electrode (130L), memory gate electrodes (130M), and an upper select gate electrode (130U1) on the plate; first channel structures (CH) extending into the lower select gate electrode and the memory gate electrodes in a first direction (Z), in the first region (R1); second channel structures (SCH) extending into the upper select gate electrode (130U1) in the first region; a horizontal insulating layer (150, 152, 154) extending in a second direction (X) between the first and second channel structures; and contact plugs (170) extending into the gate electrodes in the first direction (Z), in the second region, and wherein the horizontal insulating layer has a first thickness (T2) in the first region and a second thickness (T3) greater than the first thickness in the second region.

## Description

### BACKGROUND OF THE INVENTION

Example embodiments of the present disclosure relate to a semiconductor device and a data storage system including the same.

A semiconductor device able to store high-capacity data in a data storage system storing data has been needed. Accordingly, a method for increasing data storage capacity of a semiconductor device has been researched. For example, as a method for increasing data storage capacity of a semiconductor device, a semiconductor device including memory cells disposed three-dimensionally, instead of memory cells disposed two-dimensionally, has been suggested.

### SUMMARY OF THE INVENTION

An example embodiment of the present disclosure is to provide a semiconductor device having improved reliability.

An example embodiment of the present disclosure is to provide a data storage system including a semiconductor device having improved reliability.

According to an example embodiment of the present disclosure, a semiconductor device, comprising: a first semiconductor structure including a substrate, circuit devices on the substrate, and circuit interconnection lines on the circuit devices; and a second semiconductor structure on the first semiconductor structure and having first, second, and third regions, wherein the second semiconductor structure includes: a plate layer; gate electrodes including a lower select gate electrode, memory gate electrodes, and an upper select gate electrode on the plate layer and spaced apart from each other in a first direction perpendicular to an upper surface of the plate layer; first channel structures extending into the lower select gate electrode and the memory gate electrodes in the first direction, in the first region; second channel structures extending into the upper select gate electrode and electrically connected to the first channel structures, respectively, in the first region; a horizontal insulating layer extending in a second direction between the first channel structures and the second channel structures; and contact plugs extending into the gate electrodes in the first direction, and electrically connecting the gate electrodes to the circuit interconnection lines, in the second region, wherein the horizontal insulating layer has a first thickness in the first region and a second thickness greater than the first thickness in at least a portion of the second region, wherein the second direction is parallel with the upper surface of the plate layer, and wherein the second region is between the first region and the third region in the second direction.

According to an example embodiment of the present disclosure, a semiconductor device, comprising: a plate layer; gate electrodes on the plate layer and spaced apart from each other in a first direction perpendicular to an upper surface of the plate layer, and including first gate electrodes and a second gate electrode on the first gate electrodes; first channel structures extending into the first gate electrodes in the first direction; second channel structures extending into the second gate electrode in the first direction, and electrically connected to the first channel structures, respectively; contact plugs extending in the first direction and electrically connected to the gate electrodes, respectively; a first horizontal insulating layer extending around a portion of side surfaces of the contact plugs below the second gate electrode; and a second horizontal insulating layer on the first horizontal insulating layer, wherein the second horizontal insulating layer is between the first gate electrodes and the second gate electrode and on a portion of upper surfaces of the first channel structures.

According to an example embodiment of the present disclosure, a data storage system, comprising: a semiconductor storage device including a first semiconductor structure including circuit devices, a second semiconductor structure on the first semiconductor structure, and an input/output pad electrically connected to the circuit devices; and a controller electrically connected to the semiconductor storage device through the input/output pad and configured to control the semiconductor storage device, wherein the second semiconductor structure includes: a plate layer; gate electrodes on the plate layer and spaced apart from each other in a first direction perpendicular to an upper surface of the plate layer, and including first gate electrodes and a second gate electrode on the first gate electrodes; first channel structures extending into the first gate electrodes in the first direction; second channel structures extending into the second gate electrode in the first direction, and electrically connected to the first channel structures, respectively; a horizontal insulating layer between the first gate electrodes and the second gate electrode; and contact plugs extending into at least a portion of the gate electrodes in the first direction, and electrically connecting the gate electrodes to the first semiconductor structure, wherein the horizontal insulating layer has a first thickness on the first channel structures and a second thickness greater than the first thickness in a region adjacent to the contact plugs.

At least some of the above and other features of the invention are set out in the claims.

### BRIEF DESCRIPTION OF DRAWINGS

The above and other aspects, features, and advantages of the present disclosure will be more clearly understood from the following detailed description, taken in combination with the accompanying drawings, in which:
FIG. 1 is a plan view illustrating a semiconductor device according to example embodiments of the present disclosure;
FIGS. 2A and 2B are cross-sectional views illustrating a semiconductor device according to example embodiments of the present disclosure;
FIGS. 3A, 3B, 3C, and 3D are enlarged views illustrating a portion of regions of a semiconductor device according to example embodiments of the present disclosure;
FIGS. 4A and 4B are cross-sectional views illustrating a semiconductor device according to example embodiments of the present disclosure;
FIG. 5 is a cross-sectional view illustrating a semiconductor device according to example embodiments of the present disclosure;
FIG. 6 is a cross-sectional view illustrating a semiconductor device according to example embodiments of the present disclosure;
FIGS. 7A, 7B, 7C, 7D, 7E, 7F, 7G, 7H, 7I, 7J, 7K, 7L, 7M, and 7N are cross-sectional views illustrating a method of manufacturing a semiconductor device according to example embodiments of the present disclosure;
FIG. 8 is a view illustrating a data storage system including a semiconductor device according to an example embodiment of the present disclosure;
FIG. 9 is a perspective view illustrating a data storage system including a semiconductor device according to an example embodiment of the present disclosure; and
FIG. 10 is a cross-sectional view illustrating a semiconductor package according to an example embodiment of the present disclosure.

### DETAILED DESCRIPTION OF THE INVENTION

Hereinafter, embodiments of the present disclosure will be described as follows with reference to the accompanying drawings.

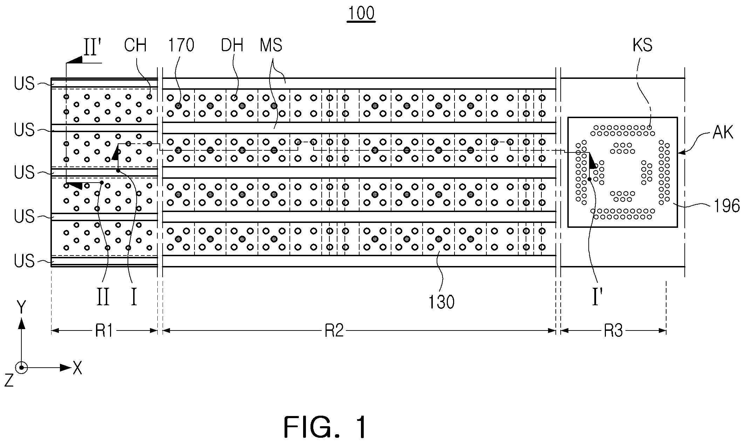

FIG. 1 is a plan view illustrating a semiconductor device according to example embodiments.

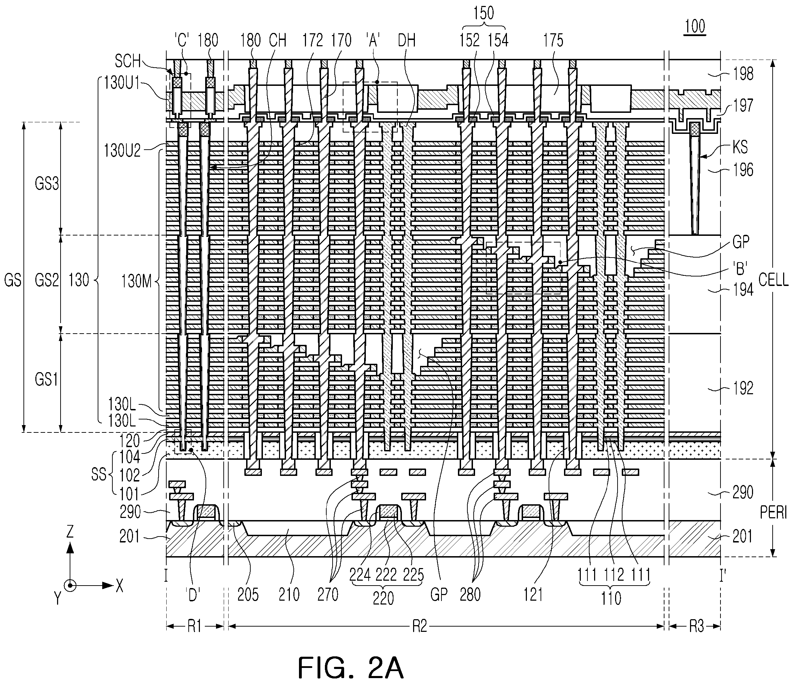

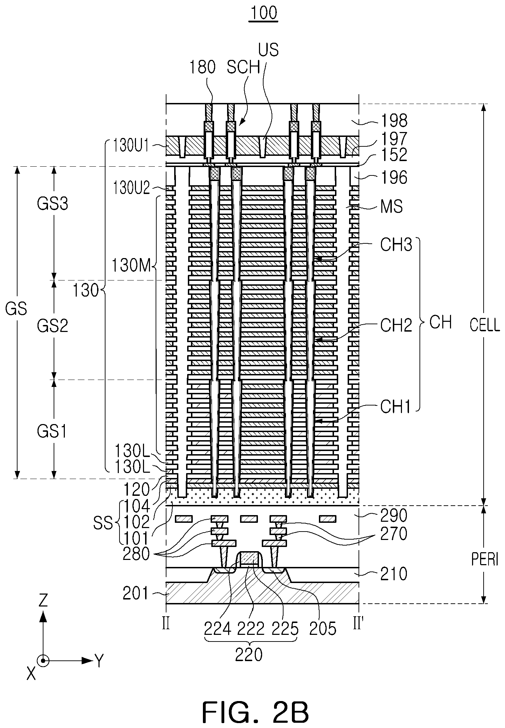

FIGS. 2A and 2B are cross-sectional views illustrating a semiconductor device according to example embodiments, taken along line I-I' and II-II' in FIG. 1.

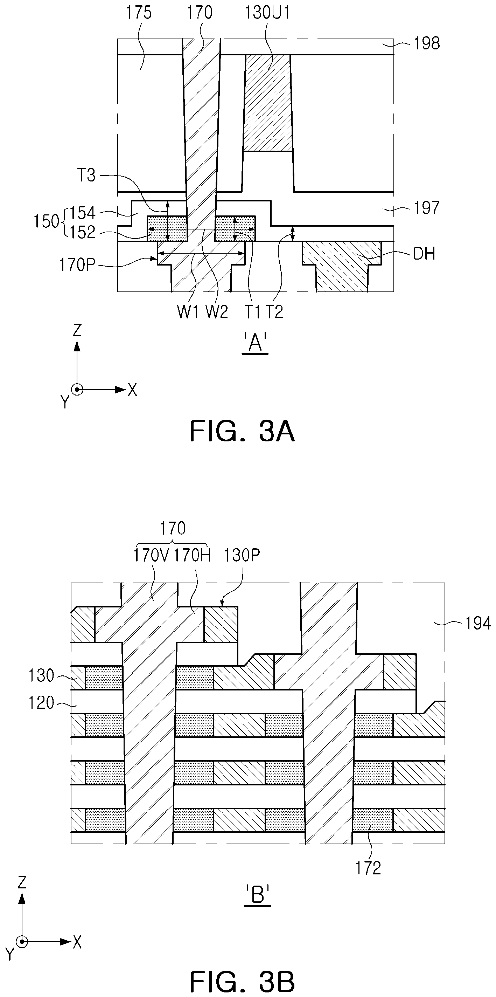

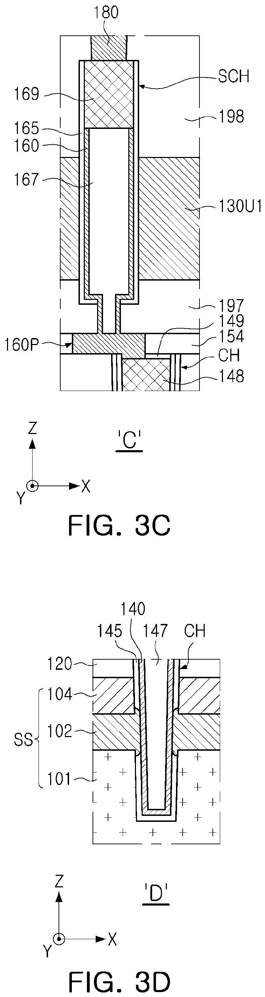

FIGS. 3A, 3B, 3C, and 3D are enlarged views illustrating a portion of regions of a semiconductor device according to example embodiments, illustrating region "A," region "B," region "C," and region "D" in FIG. 2A, respectively.

Referring to FIGS. 1, 2A, 2B, 3A, 3B, 3C, and 3D, the semiconductor device 100 may include a peripheral circuit region PERI, which may be a first semiconductor structure including a substrate 201, and a memory cell region CELL, which may be a second semiconductor structure including a plate layer 101. The memory cell region CELL may be disposed on the peripheral circuit region PERI. In example embodiments, alternatively, the memory cell region CELL may be disposed below the peripheral circuit region PERI.

The peripheral circuit region PERI may include the substrate 201, impurity regions 205 and the device isolation layers 210 in or on the substrate 201, circuit devices 220 disposed on the substrate 201, a peripheral region insulating layer 290, circuit contact plugs 270, and circuit interconnection lines 280.

The substrate 201 may have an upper surface extending in the X-direction and the Y-direction. The X-direction and the Y-direction may be parallel with the upper surface of the substrate 201 and may intersect with (may be orthogonal to) each other. Each of the X-direction and the Y-direction may be referred to as a horizontal direction. An active region may be defined on (in) the substrate 201 by the device isolation layers 210. The impurity regions 205 including impurities may be disposed in a portion of the active region. The substrate 201 may include, for example, a semiconductor material, such as a group IV semiconductor, a group III-V compound semiconductor, and/or a group II-VI compound semiconductor. The substrate 201 may be provided as a bulk wafer or an epitaxial layer. As used herein, the term "and/or" includes any and all combinations of one or more of the associated listed items.

The circuit devices 220 may include a planar transistor. Each of the circuit devices 220 may include a circuit gate dielectric layer 222, a spacer layer 224, and a circuit gate electrode 225. The impurity regions 205 may be disposed as source/drain regions in the substrate 201 on both sides (e.g., opposite sides in the horizontal direction) of the circuit gate electrode 225.

The peripheral region insulating layer 290 may be disposed on the circuit device 220 on the substrate 201. The peripheral region insulating layer 290 may include a plurality of insulating layers formed in different processes. The peripheral region insulating layer 290 may include (e.g., may be formed of) an insulating material.

The circuit contact plugs 270 and the circuit interconnection lines 280 may form a circuit interconnection structure electrically connected to the circuit devices 220 and the impurity regions 205. The circuit contact plugs 270 may have a cylindrical shape, and the circuit interconnection lines 280 may have a line shape (in a cross-sectional view). An electrical signal may be applied to the circuit device 220 through the circuit contact plugs 270 and the circuit interconnection lines 280. In regions not illustrated, the circuit contact plugs 270 may also be connected to the circuit gate electrode 225. The circuit interconnection lines 280 may be (electrically) connected to the circuit contact plugs 270 and may be disposed in plurality of layers. The circuit contact plugs 270 and the circuit interconnection lines 280 may include a conductive material, for example, tungsten (W), copper (Cu), aluminum (Al), or the like, and each component may further include a diffusion barrier. In example embodiments, the number of layers in the circuit contact plugs 270 and the circuit interconnection lines 280 may be varied. It will be understood that when an element or layer is referred to as being "on", "connected to", "responsive to", or "coupled to" another element or layer, it may be directly on, connected to, responsive to, or coupled to the other element or layer, or one or more intervening elements or layers may be present. In contrast, when an element is referred to as being "directly on", "directly connected", "directly responsive to", or "directly coupled to", another element, there are no intervening elements present. In addition, "electrical connection" conceptually includes a physical connection and a physical disconnection.

The memory cell region CELL may have first, second, and third regions R1, R2, and R3. In some embodiments, the second region R2 may be adjacent the first region R1 and the third region R3. For example, the second region R2 may be between the first region R1 and the third region R3 in the X-direction. The memory cell region CELL may include a source structure SS including a plate layer 101, gate electrodes 130 stacked on the source structure SS and forming the gate structure GS, interlayer insulating layers 120 alternately stacked with the gate electrodes 130 and form the gate structure GS, first channel structures CH disposed to extend in (e.g., penetrate) the gate structure GS (in the Z-direction) in first region R1, second channel structures SCH (electrically) connected to the first channel structures CH, respectively, first isolation regions MS extending by (at least partially) penetrating the gate structure GS (in the Z-direction), second isolation regions US (at least partially) penetrating the first upper gate electrode 130U1 disposed in an upper portion of the gate electrodes 130 (in the Z-direction), a horizontal insulating layer 150 (see Fig. 3A) disposed between the first channel structures CH and the second channel structures SCH, contact plugs 170 (electrically) connected to the gate electrodes 130 in the second region R2 and extending vertically (extending in the Z-direction), and dummy vertical structures DH disposed around (adjacent) the contact plugs 170. The Z-direction may be referred to as a vertical direction and perpendicular to the upper surface of the substrate 201. The Z-direction may intersect with (may be orthogonal to) the X-direction and the Y-direction. Herein, an upper portion of an element may refer to a portion farther than a central portion of the element from the substrate 201 in the Z-direction. A lower portion of an element may refer to a portion closer than a central portion of the element to the substrate 201 in the Z-direction.

The memory cell region CELL may include a source insulating layer 110 disposed below the gate electrodes 130 in the second region R2, a substrate insulating layer 121 disposed to extend in (e.g., penetrate) the source structure SS (in the Z-direction), an align key structure KS disposed in the third region R3, isolation insulating layers 175 extending in (e.g., penetrating) the first upper gate electrode 130U1 (in the Z-direction), studs 180 on the second channel structures SCH and the contact plugs 170, and first, second, third, fourth, and fifth cell region insulating layers 192, 194, 196, 197, and 198 on (e.g., covering) the gate electrodes 130.

In the memory cell region CELL, in the first region R1, the gate electrodes 130 may be vertically stacked (stacked in the Z-direction) and the first channel structures CH may be disposed, and memory cells may be disposed in the first region R1. In the second region R2, the gate electrodes 130 may extend to different lengths (in a horizontal direction) and may form gate pad regions GP, and the second region R2 may be a region for electrically connecting the memory cells to the peripheral circuit region PERI. The second region R2 may be disposed on (adjacent) at least one end of the first region R1 in at least one direction (one horizontal direction), for example, the X-direction. The third region R3 may be disposed on (adjacent) an external side of the second region R2 and memory cells need not be disposed in the third region R3. For example, the second region R2 may be between the first region R1 and the third region R3 in the horizontal direction (e.g., the X-direction). For example, the third region R3 may be configured as a dummy region in which a component performing electrical functions required for operation of the semiconductor device 100 is not disposed. In some example embodiments, the third region R3 may be a scribe lane region. Depending on descriptions, the first to third regions R1, R2, and R3 may be referred to as regions of the semiconductor device 100 or the plate layer 101, rather than regions of the memory cell region CELL.

FIG. 1 illustrates only a portion of components of the memory cell region CELL. For example, FIG. 1 illustrates the arrangement of the memory cell region CELL on a plane at the level of an upper surface of the second upper gate electrode 130U2, and further illustrates the second isolation regions US. A level, herein, may refer to a distance from a lower layer or a lower substrate (e.g., the substrate 201) in the vertical direction (e.g., the Z-direction). For example, a higher level may refer to a farther distance from an upper surface of the substrate 201 in the Z-direction, and a lower level may refer to a closer distance from the upper surface of the substrate 201 in the Z-direction.

The plate layer 101 may have a shape of a plate and may function as at least a portion of the common source line of the semiconductor device 100. The plate layer 101 may have an upper surface extending in the X-direction and the Y-direction. The plate layer 101 may include a conductive material. For example, the plate layer 101 may include a semiconductor material, such as a group IV semiconductor, a group III-V compound semiconductor, and/or a group II-VI compound semiconductor. For example, a group IV semiconductor may include silicon, germanium, and/or silicon-germanium. The plate layer 101 may further include impurities. For example, the plate layer 101 may be provided as a polycrystalline semiconductor layer such as a polycrystalline silicon layer or an epitaxial layer.

In an embodiment, the plate layer 101 may be disposed in the entirety of the first to third regions R1, R2, and R3. However, in some example embodiments, the plate layer 101 need not be disposed in the third region R3. In this case, in the third region R3, the source insulating layer 110 and the second horizontal conductive layer 104 (which will be described later) need not be disposed, and at least one insulating layer may be disposed in positions corresponding to the plate layer 101, the source insulating layer 110, and the second horizontal conductive layer 104.

The first and second horizontal conductive layers 102 and 104 may be stacked in order and disposed on an upper surface of the plate layer 101 in the first region R1. The first and second horizontal conductive layers 102 and 104 together with the plate layer 101 may form the source structure SS. The source structure SS may function as a common source line for the semiconductor device 100. As illustrated in FIG. 3D, the first horizontal conductive layer 102 may be directly connected to (may be in direct contact with) the first channel layer 140 around the first channel layer 140. For example, the first horizontal conductive layer 102 may extend around a portion of the first channel layer 140.

The first and second horizontal conductive layers 102 and 104 may include a semiconductor material, for example, polycrystalline silicon. In some embodiments, at least the first horizontal conductive layer 102 may be doped with impurities of the same conductivity type as the plate layer 101. The second horizontal conductive layer 104 may be a doped layer or a layer including diffused impurities from the first horizontal conductive layer 102. In some example embodiments, an insulating layer having a relatively small thickness may be interposed between the first horizontal conductive layer 102 and the second horizontal conductive layer 104.

The source insulating layer 110 may be disposed on the plate layer 101 on the same level as a level of the first horizontal conductive layer 102 in at least a portion of the second region R2 and the third region R3. The source insulating layer 110 may include first and second source insulating layers 111 and 112 alternately stacked on the plate layer 101. The source insulating layer 110 may be layers remaining after a portion thereof is replaced with the first horizontal conductive layer 102 in a process of manufacturing the semiconductor device 100.

The source insulating layer 110 may include, for example, silicon oxide, silicon nitride, silicon carbide, and/or silicon oxynitride. The first source insulating layer 111 and the second source insulating layer 112 may include different insulating materials. For example, the first source insulating layers 111 may be formed of the same material as that of the interlayer insulating layers 120, and the second source insulating layer 112 may be formed of a material different from the interlayer insulating layers 120.

The substrate insulating layers 121 may extend in (e.g., penetrate) the plate layer 101, the source insulating layer 110, and the second horizontal conductive layer 104 in a portion of the second region R2. An upper surface of the substrate insulating layer 121 may be coplanar with an upper surface of the second horizontal conductive layer 104. The substrate insulating layer 121 may include an insulating material, for example, silicon oxide, silicon nitride, silicon carbide, and/or silicon oxynitride.

A portion of the gate electrodes 130 may be vertically stacked and spaced apart from each other on the plate layer 101 and may form a gate structure GS together with the interlayer insulating layers 120. The gate structure GS may include first, second, and third stack structures GS1, GS2, and GS3, vertically stacked. However, in example embodiments, the number of stack structures forming the gate structure GS may be varied. For example, in some example embodiments, the gate structure GS may include four or more stack structures or may include a single stack structure. The number of the gate electrodes 130 forming the first, second, and third stack structures GS1, GS2, and GS3 may be the same or different.

The gate electrodes 130 may include a first upper gate electrode 130U1 forming string select transistors, a second upper gate electrode 130U2 forming an erase transistor, memory gate electrodes 130M forming a plurality of memory cells, and lower gate electrodes 130L forming an erase transistor and a ground select transistor. Depending on capacity of the semiconductor device 100, the number of the memory gate electrodes 130M included in the memory cells may be determined. The first upper gate electrode 130U1 and the lower gate electrodes 130L may also be referred to as an upper select gate electrode and a lower select gate electrode, respectively. In example embodiments, each of the first upper gate electrode 130U1, the second upper gate electrode 130U2, and the lower gate electrodes 130L may be in plural. For example, the semiconductor device 100 may include more than one (e.g., 1 to 4) first upper gate electrode 130U1, one (e.g., 1 to 4) second upper gate electrode 130U2, and one (e.g., 1 to 4) lower gate electrode 130L. Each of the first upper gate electrode 130U1, the second upper gate electrode 130U2, and the lower gate electrode 130L may have a structure the same as or different from the memory gate electrodes 130M. In some example embodiments, the second upper gate electrode 130U2 and/or at least one lower gate electrode 130L need not be provided (may be omitted). A portion of the gate electrodes 130, for example, the memory gate electrodes 130M adjacent to the second upper gate electrode 130U2 or the lower gate electrodes 130L, may be dummy gate electrodes.

As illustrated in FIG. 1, the gate electrodes 130 may be isolated from each other in the Y-direction by the first isolation regions MS (continuously) extending in the first region R1 and/or the second region R2. The gate electrodes 130 between a pair of (adjacent) the first isolation regions MS may form a memory block, but an example embodiment thereof is not limited thereto.

Among the gate electrodes 130, the gate electrodes 130 other than the first upper gate electrode 130U1 may be referred to as first gate electrodes. For example, the first gate electrodes may include the second upper gate electrode 130U2, the memory gate electrodes 130M, and the lower gate electrodes 130L. The first gate electrodes may form a gate structure GS. The first upper gate electrode 130U1 may also be referred to as a second gate electrode, and may have a relatively great thickness in an uppermost portion of the gate electrode 130. For example, the second gate electrode (the first upper gate electrode 130U1) is on the first gate electrodes (the second upper gate electrode 130U2, the memory gate electrodes 130M, and the lower gate electrodes 130L) and may have a greater thickness in the Z-direction than that of each of the first gate electrodes.

The gate electrodes 130 may be vertically stacked and spaced apart from each other on the first region R1, and the first gate electrodes may extend from the first region R1 to the second region R2 in different lengths (in the X-direction and/or the Y-direction) and may form a step structure in a staircase form in the gate pad regions GP. As illustrated in FIG. 2A, the first gate electrodes may have a shape in which the first gate electrodes may be removed at a predetermined depth (in the Z-direction) from an upper portion of one of the first to third stack structures GS1, GS2, and GS3 in the gate pad regions GP. Herein, a depth may refer to a certain length in the Z-direction from a certain element toward the substrate 201 below the certain element. The gate pad regions GP may be disposed to not overlap each other in the Z-direction. The gate electrodes 130 forming an upper portion of the gate structure GS (e.g., the second and/or third stack structures GS2 and/or GS3) may extend horizontally on the gate pad regions GP of a lower portion of the gate structure GS (e.g., the first and/or second stack structures GS1 and/or GS2). In an example embodiment, the gate pad regions GP may be disposed in order in the first stack structure GS1, the second stack structure GS2, and the third stack structure GS3 in the X-direction from the first region R1. For example, the gate pad region GP in the first stack structure GS1 may be closest to the first region R1 in the X-direction, and the gate pad region GP in the third stack structure GS3 may be farthest from the first region R1 in the X-direction. Only one gate pad region GP may be disposed in each of the first and second stack structures GS1 and GS2 in the drawings, but a plurality of gate pad regions GP may be disposed in each of the first to third stack structures GS1, GS2, and GS3. However, in example embodiments, the arrangement form, the arrangement order, and the depth of the gate pad regions GP may be varied. In some example embodiments, the gate electrodes 130 is not disposed on the gate pad regions GP.

The gate electrodes 130 may form a first and second step structure in an asymmetric form in the X-direction in each of the gate pad regions GP. The first step structure maybe a staircase structure relatively adjacent (e.g., closer) to the first region R1 and a level thereof may decrease in the X-direction (e.g., a horizontal direction away from the first region R1), and the second step structure may have a staircase structure spaced apart (farther) from the first region R1 and having a level increasing in the X-direction (e.g., a horizontal direction away from the first region R1). For example, in each of the gate pad regions GP, a slope of the first step structure may be smaller (e.g., less steep) than a slope of the second step structure. In the first step structure, the gate electrodes 130 may be (electrically) connected to the contact plugs 170, and in the second step structure, the gate electrodes 130 may form a dummy region or a dummy structure not (electrically) connected to the contact plugs 170. In example embodiments, a specific shape of the step structure, and the number of the gate electrodes 130 included in each step structure are not limited to the example illustrated in FIG. 2A. In some example embodiments, the gate electrodes 130 may be disposed to have a step structure in the Y-direction.

As illustrated in FIG. 3B, due to the first step structure, the gate electrodes 130 of the lower portion may extend longer than the gate electrode 130 in an upper portion, and may have contact regions 130P upwardly exposed from the interlayer insulating layers 120. The gate electrodes 130 may be (electrically) connected to the contact plugs 170 through contact regions 130P, which may be end regions (of the gate electrodes 130), respectively. The gate electrodes 130 other than the first upper gate electrode 130U1 may have an increased thickness in the contact regions 130P. The first upper gate electrode 130U1 may be (electrically) connected to a contact plug (other than the contact plugs 170), which does not penetrate the first upper gate electrode 130U1.

The gate electrodes 130 may include a conductive material such as a metal material or a semiconductor material. For example, the first gate electrodes (e.g., the second upper gate electrode 130U2, the memory gate electrodes 130M, and the lower gate electrodes 130L) may include tungsten (W), and the second gate electrode, that is, a first upper gate electrode 130U1, may include polycrystalline silicon. In example embodiments, at least a portion of the gate electrodes 130 may further include a diffusion barrier. For example, the diffusion barrier may include tungsten nitride (WN), tantalum nitride (TaN), titanium nitride (TiN), and/or a combination thereof.

The interlayer insulating layers 120 may be disposed between the gate electrodes 130. Similarly to the gate electrodes 130, the interlayer insulating layers 120 may be spaced apart from each other in a direction perpendicular to an upper surface of the plate layer 101 (e.g., in the Z-direction) and may extend in the X-direction. The interlayer insulating layers 120 may include an insulating material such as silicon oxide or silicon nitride. In example embodiments, a thickness of each of the interlayer insulating layers 120 may be varied.

The first channel structures CH may extend in the Z-direction by penetrating the gate electrodes 130 other than the first upper gate electrode 130U1, and may be (electrically) connected to the plate layer 101. Each of the first channel structures CH, together with the second channel structures SCH, may form a memory cell string, and may be spaced apart from each other in rows and columns on the plate layer 101 in the first region R1. The first channel structures CH may be disposed to form a grid pattern on the X-Y plane or may be disposed in a zigzag pattern in one direction. The first channel structures CH may have a column shape (in a cross-sectional view) and may have an inclined side surface so that a width of the first channel structure CH (in the X-direction and/or the Y-direction) decreases as the first channel structure CH extends toward the plate layer 101.

The first channel structures CH may include first, second, and third channel portions CH1, CH2, and CH3, vertically stacked. The first, second, and third channel portions CH1, CH2, and CH3 may extend in (e.g., penetrate) the first, second, and third stack structures GS1, GS2, and GS3 of the gate structure GS, respectively. In the first channel structure CH, an upper portion of the first channel portion CH1 and (a lower portion of) the second channel portion CH2 may be connected to each other, and an upper portion of the second channel portion CH2 and (a lower portion of) the third channel portion CH3 may be connected to each other. The first, second, and third channel portions CH1, CH2, and CH3 may have a shape in which a width of an upper surface of the channel portion disposed in a lower portion may be greater than a width of a lower surface of the channel portion disposed in an upper portion, in regions in which the channel portions are connected to each other, or at interfacial surfaces therebetween. For example, an upper surface of the first channel portion CH1 may have a width in a horizontal direction greater than that of a lower surface of the second channel portion CH2. The upper surface of the first channel portion CH1 and the lower surface of the second channel portion CH2 may be connected to each other at the same level. An upper surface of the second channel portion CH2 may have a width in a horizontal direction greater than that of a lower surface of the third channel portion CH3. The upper surface of the second channel portion CH2 and the lower surface of the third channel portion CH3 may be connected to each other at the same level. The first channel structure CH may have bent portions due to differences in width on interfacial surfaces between the first and second channel portions CH1 and CH2 and between the second and third channel portions CH2 and CH3. However, in example embodiments, the number of channel portions stacked in the Z-direction in the first channel structure CH may be varied. The first channel portion CH1 may partially penetrate the source structure SS, and a lower end of the first channel portion CH1 may be disposed in the plate layer 101.

Each of the first channel structures CH may include a first channel layer 140, a first gate dielectric layer 145, a first channel filling insulating layer 147, a first channel pad 148, and an upper end insulating layer 149 disposed in a lower channel hole. The lower channel hole may be a region in which the first channel structure CH is formed in the gate structure GS (e.g., the first, second, and third stack structures GS1, GS2, and GS3). The first channel layer 140, the first gate dielectric layer 145, and the first channel filling insulating layer 147 may be continuous between the first, second, and third channel portions CH1, CH2, and CH3.

As illustrated in the enlarged view in FIG. 3D, the first channel layer 140 may be formed as an annular shape extending around (e.g., surrounding) the first channel filling insulating layer 147. In some examples, the first channel layer 140 may have a pillar shape such as a cylindrical shape or a prism shape without the first channel filling insulating layer 147 therein. The first channel layer 140 may have a lower portion that is (directly) connected to the first horizontal conductive layer 102. The first channel layer 140 may include, for example, a semiconductor material such as polycrystalline silicon or single crystalline silicon.

The first gate dielectric layer 145 may be disposed between the gate electrodes 130 and the first channel layer 140. Although not specifically illustrated, the first gate dielectric layer 145 may include a tunneling layer, a charge storage layer, and a blocking layer stacked in order on (from) the first channel layer 140. The tunneling layer may tunnel charges into the charge storage layer and may include, for example, silicon oxide (SiO₂), silicon nitride (Si₃N₄), silicon oxynitride (SiON), and/or a combination thereof. The charge storage layer may be a charge trap layer or a floating gate conductive layer. The blocking layer may include, for example, silicon oxide (SiO₂), silicon nitride (Si₃N₄), silicon oxynitride (SiON), a high-κ dielectric material (having a diecletric constant equal or greater than that of silicon dioxide), and/or a combination thereof. In example embodiments, at least a portion of the first gate dielectric layer 145 may extend in a horizontal direction along the gate electrodes 130.

The first channel pad 148 may be disposed only on an upper portion (e.g., an upper end) of the third channel portion CH3. The first channel pad 148 may include, for example, doped polycrystalline silicon. The upper end insulating layer 149 may be disposed on the first channel pad 148 as illustrated in FIG. 3C. The upper end insulating layer 149 may include an insulating material, and may be, for example, an oxidation layer formed of a material in (forming) the first channel pad 148.

The second channel structures SCH may penetrate the first upper gate electrode 130U1 and may extend in the Z-direction, and may be (electrically) connected to the first channel structures CH, respectively. The second channel structures SCH may be disposed on the first channel structures CH, respectively, and may be disposed by being shifted in a horizontal direction from the first channel structures CH. For example, a center point of the first channel structure CH may be spaced apart from a center point of the second channel structure SCH in a horizontal direction (in the X-direction), but an example embodiment thereof is not limited thereto.

As illustrated in FIG. 3C, the second channel structures SCH may include a second channel layer 160, a second gate dielectric layer 165, a second channel filling insulating layer 167, and a second channel pad 169, disposed in an upper channel hole. The upper channel hole may be a region in which the second channel structure SCH is formed on the gate structure GS. The second channel layer 160 may be formed as an annular structure (an annular shape) extending around (e.g., surrounding) an internal second channel filling insulating layer 167. The second channel layer 160 may include a connection pad portion 160P enlarged horizontally along the second horizontal insulating layer 154 in a lower portion, and may be (electrically) connected to the first channel layer 140 of the first channel structure CH through the connection pad portion 160P and the first channel pad 148. For example, the connection pad portion 160P may be between the first channel pad 148 and the second channel filling insulating layer 167 in the Z-direction.

The descriptions of the materials of the first channel layer 140, the first gate dielectric layer 145, the first channel filling insulating layer 147, and the first channel pad 148 described above may be applied to the description of the materials of the second channel layer 160, the second gate dielectric layer 165, the second channel filling insulating layer 167, and the second channel pad 169, respectively.

The horizontal insulating layer 150 may be disposed between the first channel structures CH and at least a portion of the second channel structures SCH, and at least a portion of the horizontal insulating layer 150 may extend horizontally. In some embodiments, the horizontal insulating layer 150 (e.g., first horizontal insulating layer 152) may be on the gate structure GS (e.g., the third stack structure GS3). For example, the horizontal insulating layer 150 may be between the first channel structure CH and the fourth cell region insulating layer 197 in the Z-direction. The horizontal insulating layer 150 may include first horizontal insulating layers 152 and a second horizontal insulating layer 154 on the first horizontal insulating layers 152.

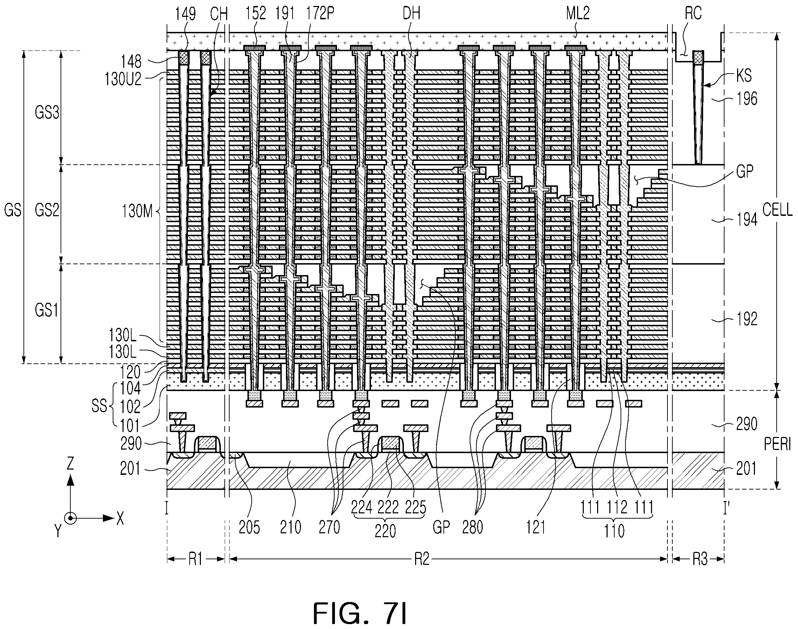

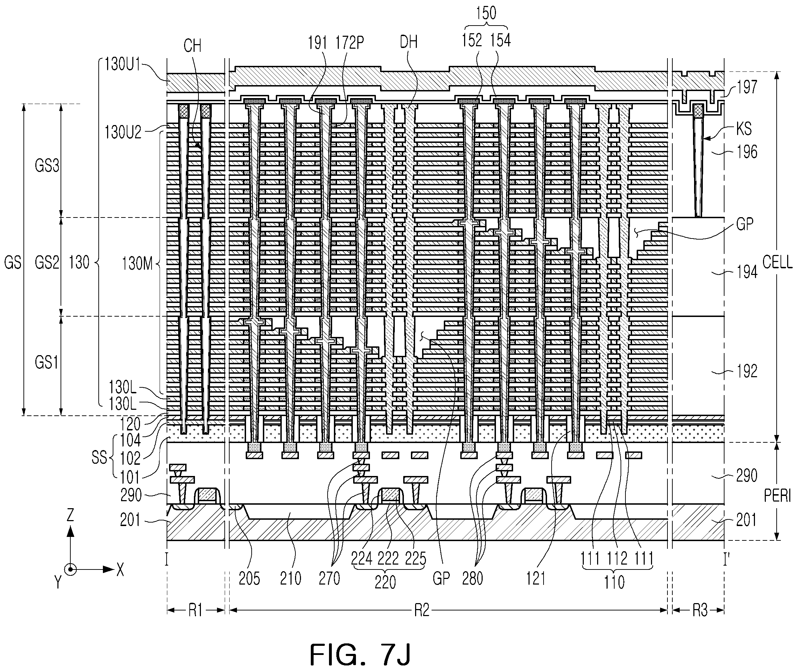

The first horizontal insulating layers 152 may be disposed in at least a portion of the second region R2 and may be disposed in a region adjacent to the contact plugs 170. For example, the first horizontal insulating layers 152 may be on the gate structure GS (e.g., the third stack structure GS3). The first horizontal insulating layer 152 may be disposed to surround a portion of a side surface of the contact plug 170. The first horizontal insulating layer 152 may be on (in contact with) a portion of a side surface of the contact plug 170 and an upper surface of a protrusion 170P. The protrusion 170P of the contact plug 170 may have a greater width in a horizontal direction than those of adjacent portions of the contact plug 170. The upper surface of the protrusion 170P may be coplanar with an upper surface of the third stack structure GS3. The first horizontal insulating layers 152 may prevent vertical sacrificial layers 191 (to be described later) for forming the contact plugs 170 from being exposed during the manufacturing process, thereby forming the contact plugs 170 without defects, which will be described in greater detail with reference to FIGS. 7I and 7J.

The first horizontal insulating layer 152 need not be disposed (may be omitted) in the first region R1 and the third region R3. The first horizontal insulating layer 152 need not extend to the first channel structures CH and may be spaced apart from the first channel structures CH in the horizontal direction. The first horizontal insulating layers 152 may be disposed on a level the same as or higher than a level of upper surfaces of the first channel structures CH. A level of lower surfaces of the first horizontal insulating layers 152 may be (substantially) the same as a level of upper surfaces of the first channel structures CH. The first horizontal insulating layer 152 may completely cover (e.g., overlap in the Z-direction) the upper surface of the protrusion 170P of the contact plug 170. A second width W2 of the first horizontal insulating layer 152 may be equal to or greater than the first width W1 of the protrusion 170P of the contact plug 170 in a horizontal direction. The second width W2 of the first horizontal insulating layer 152 may refer to a distance between the opposite outer sidewalls of the first horizontal insulating layer 152 in a horizontal direction. For example, the second width W2 of the first horizontal insulating layer 152 may include a width of a portion of the contact plug 170 in a horizontal direction surrounded by the first horizontal insulating layer 152.

The second horizontal insulating layer 154 may extend horizontally throughout the first, second, and third regions R1, R2, and R3. The second horizontal insulating layer 154 may be disposed between the first upper gate electrode 130U1 and the second upper gate electrode 130U2, and between the first channel structures CH and the second channel structures SCH. The second horizontal insulating layer 154 may be on (e.g., cover or overlap in the Z-direction) a portion of an upper surface of the first channel structure CH. The second horizontal insulating layer 154 may be on (e.g., in contact with), for example, the upper end insulating layer 149. The second horizontal insulating layer 154 may be used as an etch stop layer when the second channel structures SCH is formed, and may also be used when the connection pad portion 160P is formed. The second horizontal insulating layer 154 may be on (e.g., cover or overlap in the Z-direction) upper surfaces of the first horizontal insulating layers 152 and upper surfaces of dummy vertical structures DH in the second region R2. The second horizontal insulating layer 154 may be on (e.g., cover or overlap) an upper surface and a portion of a side surface of the align key structure KS in the third region R3.

The horizontal insulating layer 150 may have a second thickness T2 (e.g., in the Z-direction) in the first region R1, a portion of the second region R2, and the third region R3, and a third thickness T3 (e.g., in the Z-direction) greater than the second thickness T2 in another portion of the second region R2. Specifically, the first horizontal insulating layer 152 may have a first thickness T1 (e.g., in the Z-direction), and the second horizontal insulating layer 154 may have the second thickness T2. The horizontal insulating layer 150 may have the second thickness T2 when the first horizontal insulating layer 152 is omitted. The horizontal insulating layer 150 may have the third thickness T3 when the first horizontal insulating layer 152 is provided. Accordingly, in a portion of the second region R2, the horizontal insulating layer 150 may have the third thickness T3, which may be the sum of the first thickness T1 and the second thickness T2. The first thickness T1 of the first horizontal insulating layer 152 may be greater than the second thickness T2 of the second horizontal insulating layer 154. For example, a difference between the third thickness T3 and the second thickness T2, that is, the first thickness T1, may be in a range of (about) 100 angstroms (Å) to (about) 300 Å. However, in example embodiments, the first thickness T1 may be equal to or smaller than the second thickness T2, and relative sizes of the first thickness T1 and the second thickness T2 may be varied. Accordingly, levels of the upper and lower surfaces of the first upper gate electrode 130U1 on a region in which the horizontal insulating layer 150 may have the third thickness T3, that is, the region in which the first horizontal insulating layer 152 is disposed, may be higher than levels of the upper and lower surfaces of the first upper gate electrode 130U1 on a region in which the horizontal insulating layer 150 has the second thickness T2 (that is, the region in which the first horizontal insulating layer 152 is omitted), respectively.

The horizontal insulating layer 150 may include an insulating material and may include a material different from those of the third and fourth cell region insulating layers 196 and 197. The horizontal insulating layer 150 may include nitride, for example, SiN, SiON, SiCN, and/or SiOCN. The first and second horizontal insulating layers 152 and 154 may include the same material.

The first isolation regions MS may be disposed to extend in (e.g., penetrate) at least a portion of the gate electrodes 130 and may extend in the X-direction. The first isolation regions MS may be disposed to penetrate the gate electrodes 130 other than the first upper gate electrode 130U1. As illustrated in FIG. 1, the first isolation regions MS may be parallel to each other. However, the arrangement form and the number of the first isolation regions MS are not limited to the illustrated examples in FIG. 1. For example, a portion of the isolation regions MS may extend as an integrated region along the first region R1 and the second region R2, and the other portion may extend only to a portion of the second region R2, or may be disposed intermittently in the first region R1 and the second region R2.

As illustrated in FIG. 2B, the first isolation regions MS may extend in (e.g., penetrate) (at least) a portion of the gate electrodes 130 stacked on the plate layer 101, may further penetrate the first and second horizontal conductive layers 102 and 104 therebelow, and may be (electrically) connected to the plate layer 101. The first isolation regions MS may have a shape of which a width (in a horizontal direction) may decrease toward the plate layer 101 due to a high aspect ratio. The first isolation regions MS may include regions protruding from side surfaces toward the gate electrodes 130. The first isolation regions MS may include an insulating material, for example, silicon oxide, silicon nitride, and/or silicon oxynitride.

The second isolation regions US may extend in the X-direction on (above) the first isolation regions MS and between the first isolation regions MS adjacent to each other (in the Y-direction). The second isolation regions US may penetrate the first upper gate electrode 130U1 disposed in an uppermost portion of the gate electrodes 130. The second isolation regions US may divide the first upper gate electrode 130U1 in the Y-direction as illustrated in FIG. 2B. The second isolation regions US may include an insulating material, for example, silicon oxide, silicon nitride, and/or silicon oxynitride.

The isolation insulating layers 175 may penetrate the first upper gate electrode 130U1 in the second region R2. The isolation insulating layers 175 may extend around (e.g., surround) the contact plugs 170 as a predetermined unit and may be further disposed on dummy vertical structures DH. In some example embodiments, the isolation insulating layer 175 surrounding the contact plugs 170 may be connected to the isolation insulating layer 175 on the dummy vertical structures DH. Alternatively, the isolation insulating layers 175 surrounding each of the contact plugs 170 may be spaced apart from the isolation insulating layers 175 on each of the dummy vertical structures DH. The isolation insulating layers 175 may include an insulating material, for example, silicon oxide, silicon nitride, and/or silicon oxynitride.

The contact plugs 170 may be (electrically) connected to the contact regions 130P of the gate electrodes 130 in the gate pad regions GP of the second region R2. The contact plugs 170 may extend in (e.g., penetrate) at least a portion of the first, second, and third cell region insulating layers 192, 194, and 196, and may be (electrically) connected to the contact regions 130P of the gate electrodes 130 exposed in an upper portion (e.g., exposed upwardly), respectively. The contact plugs 170 may further extend in (e.g., penetrate) fourth and fifth cell region insulating layers 197 and 198, an isolation insulating layer 175, and first and second horizontal insulating layers 152 and 154 (in an upper portion of the semiconductor device 100). The contact plugs 170 may extend in (e.g., penetrate) the gate electrodes 130 below the contact regions 130P, may extend in (e.g., penetrate) the second horizontal conductive layer 104, the source insulating layer 110, and the plate layer 101 and may be (electrically) connected to the circuit interconnection lines 280 in the peripheral circuit region PERI. The contact plugs 170 may be spaced apart from the gate electrodes 130 below the contact regions 130P by the contact insulating layers 172. The contact plugs 170 may be spaced apart from the plate layer 101, the source insulating layer 110, and the second horizontal conductive layer 104 by the substrate insulating layers 121. However, in some example embodiments, the contact plugs 170 may be disposed to not penetrate the entire gate electrodes 130. For example, each contact plug 170 may extend only to the gate electrode 130 electrically connected thereto.

The contact plugs 170 may have a shape corresponding to the channel structures CH. Each of the contact plugs 170 may include a lower region, an intermediate region, and an upper region extending in (e.g., penetrating) the first, second, and third stack structures GS1, GS2, and GS3, respectively. The upper region (of the contact plug 170) may have a protrusion 170P of which a width (in a horizontal direction) may increase below the horizontal insulating layer 150 as illustrated in FIG. 3A. The lower region (of the contact plug 170) may further extend in (e.g., penetrate) the substrate insulating layer 121. Each of the lower region, the intermediate region, and the upper region (of the contact plug 170) may have a cylindrical shape of which a width (in a horizontal direction) may decrease toward the substrate 201 due to an aspect ratio. Each of the contact plugs 170 may further include a landing region of which a width (in a horizontal direction) may be enlarged below the substrate insulating layer 121. However, in some example embodiments, the contact plugs 170 do not include a landing region.

As illustrated in FIG. 3B, each of the contact plugs 170 may have a horizontally enlarged shape in (at) the contact region 130P. The contact plug 170 may include a vertical extension portion 170V extending in the Z-direction and a horizontal extension portion 170H extending horizontally from the vertical extension portion 170V and in contact with the gate electrode 130. The horizontal extension portion 170H may be disposed along a circumference of the vertical extension portion 170V, and the entire side surface thereof may be surrounded by the gate electrode 130. A length from a side surface of the vertical extension portion 170V to an end of the horizontal extension portion 170H (in a horizontal direction) may be smaller than a length from a side surface of the vertical extension portion 170V to external side surfaces of the contact insulating layers 172 (in the horizontal direction). The contact plugs 170 may be separated from the gate electrodes 130 below the contact regions 130P, that is, the gate electrodes 130 not electrically connected thereto, by the contact insulating layers 172.

The contact plugs 170 may include a conductive material, for example, tungsten (W), copper (Cu), aluminum (Al), and/or alloys thereof. In some example embodiments, the contact plugs 170 may include a barrier layer extending along a side surface and a lower surface (e.g., a bottom surface), and/or may have an air gap therein.

The contact insulating layers 172 may be disposed to extend around (e.g., surround) side surfaces of the contact plugs 170 below the contact regions 130P. The contact insulating layers 172 may be spaced apart from each other in the Z-direction on circumferences of the contact plugs 170, respectively. The contact insulating layers 172 may be disposed on (substantially) the same level as a level of the gate electrodes 130, respectively. The contact insulating layers 172 may include an insulating material, for example, silicon oxide, silicon nitride, and/or silicon oxynitride.

The dummy vertical structures DH may be spaced apart from each other in rows and columns on the plate layer 101 in the second region R2. As illustrated in FIG. 1, the dummy vertical structures DH may be disposed to surround the contact plugs 170 in four directions, respectively. The dummy vertical structures DH may be disposed regularly and continuously even in regions in which the contact plugs 170 are spaced apart from each other in the X-direction. However, in example embodiments, the arrangement form of the dummy vertical structures DH may be varied. The dummy vertical structures DH may have a circular shape, an oval shape, or a shape similar thereto on the plane view. The dummy vertical structures DH may have a pillar shape extending in (e.g., penetrating) at least a portion of the gate electrodes 130, and may have an inclined side surface of which a width (in a horizontal direction) may decrease toward the plate layer 101 depending on an aspect ratio. A diameter or a maximum width (in a horizontal direction) of the dummy vertical structures DH may be greater than a diameter (or a width in the horizontal direction) of the first channel structures CH, but an example embodiment thereof is not limited thereto.

The dummy vertical structures DH may be disposed below the horizontal insulating layer 150. Upper surfaces of the dummy vertical structures DH may be covered by (overlapped with) the second horizontal insulating layer 154. The first horizontal insulating layer 152 need not be disposed on the dummy vertical structures DH. Similarly to contact plugs 170, the dummy vertical structures DH may include an enlarged region on an upper end thereof, but an example embodiment thereof is not limited thereto. The dummy vertical structures DH may include regions protruding from side surfaces toward the gate electrodes 130.

The dummy vertical structures DH need not include a conductive layer and may include an insulating material. The dummy vertical structures DH may include, for example, silicon oxide, silicon nitride, and/or silicon oxynitride.

The align key structure KS may be disposed in the third region R3, and may be arranged in a predetermined pattern in the align key AK as illustrated in FIG. 1. The align key AK may be configured for alignment between upper and lower patterns in a photolithography process during the process of manufacturing the semiconductor device 100. For example, the align key structure KS may be used in the process of aligning the second channel structures SCH with the first channel structures CH. One or more align keys AK may be disposed, and the shape and the size of the pattern formed by the align key structures KS in the align key AK may be varied in example embodiments.

The align key structure KS may be disposed on the same level as levels of the third stack structure GS3 and the third channel portions CH3. The align key structure KS may extend in (e.g., penetrate) the third cell region insulating layer 196 and may be in contact with the second cell region insulating layer 194. An upper surface of the align key structure KS may be disposed on (substantially) the same level as a level of upper surfaces of the first channel structures CH and lower surfaces of the first horizontal insulating layers 152. The align key structure KS may have a structure corresponding to at least an upper region of the first channel structure CH. The align key structure KS may have an internal structure similar to that of the third channel portion CH3. The align key structure KS may have the same internal structure as that of the third channel portion CH3 in a region other than a lower end, and each of the layers included in the align key structure KS may extend to cover or overlap a lower surface (e.g., a bottom surface) on the lower end. A diameter of the align key structure KS may be equal to or greater than a diameter of the first channel structure CH. In some example embodiments, the align key structure KS may have a wall shape extending in one direction instead of a pillar shape. In some example embodiments, the align key structure KS may further include a region corresponding to the second channel portion CH2.

The third cell region insulating layer 196 may have a recess region extending around (e.g., surrounding) an upper region of the align key structure KS. The align key structure KS may protrude into (protrude upwardly from) the recess region. An upper surface of the (protruding) align key structure KS and a portion of a side surface extending from the upper surface may be covered or overlapped by the second horizontal insulating layer 154. Each of the fourth cell region insulating layer 197 and the first upper gate electrode 130U1 may have recessed regions due to the align key structure KS. The align key structure KS and/or the recessed regions (of the fourth cell region insulating layer 197 and the first upper gate electrode 130U1) may function as an align key for alignment between upper and lower patterns during the process of manufacturing the semiconductor device 100 as described above.

In some example embodiments, the third region R3 may be removed during the process of manufacturing the semiconductor device 100. In this case, the semiconductor device 100 need not, ultimately, include the third region R3 and the align key structure KS.

The studs 180 may form a cell interconnection structure electrically connected to the memory cells in the memory cell region CELL. The studs 180 may be (electrically) connected to the second channel structures SCH and the contact plugs 170, and may be electrically connected to the first channel structures CH and the gate electrodes 130. The studs 180 may have a plug shape, but an example embodiment thereof is not limited thereto, and may also have a line shape. The studs 180 may include metal, for example, tungsten (W), copper (Cu), aluminum (Al), and/or the like

The first, second, third, fourth, and fifth cell region insulating layers 192, 194, 196, 197, and 198 may be disposed on (to cover) the first, second, and third stack structures GS1, GS2, and GS3, the horizontal insulating layer 150, and the first upper gate electrode 130U1, respectively. Each of the first, second, third, fourth, and fifth cell region insulating layers 192, 194, 196, 197, and 198 may include a plurality of insulating layers in some example embodiments. The first, second, third, fourth, and fifth cell region insulating layers 192, 194, 196, 197, and 198 may be formed of an insulating material, and may include, for example, silicon oxide, silicon nitride, and/or silicon oxynitride.

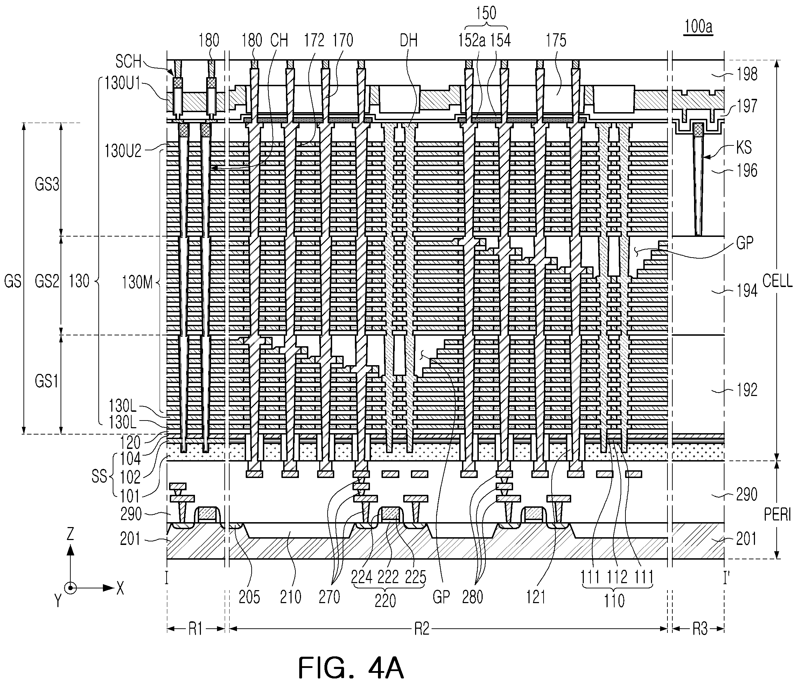

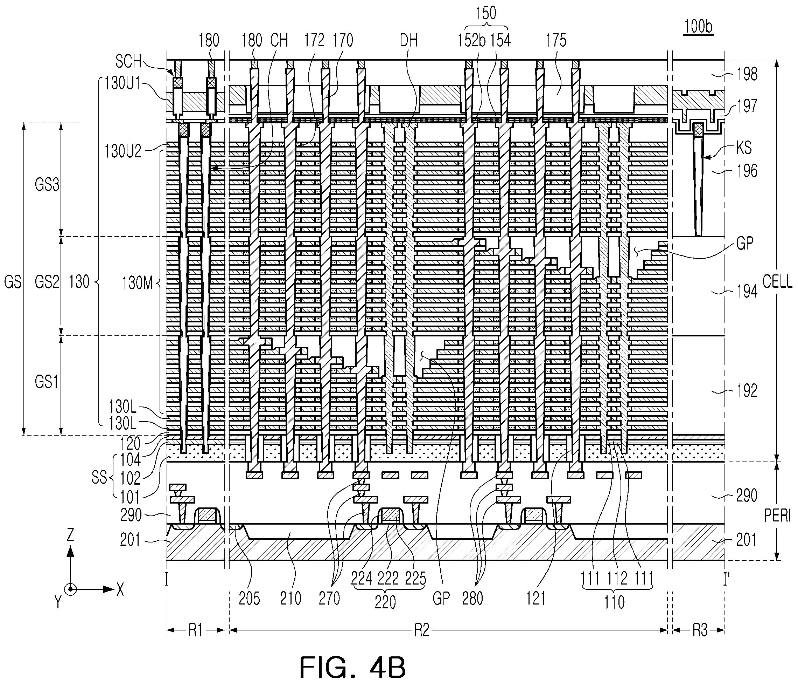

FIGS. 4A and 4B are cross-sectional views illustrating a semiconductor device according to example embodiments, illustrating a region corresponding to FIG. 2A.

Referring to FIG. 4A, in a semiconductor device 100a, each of first horizontal insulating layers 152a may be disposed to extend around (e.g., surround) side surfaces of a plurality of contact plugs 170 in a second region R2. In the example embodiment, the first horizontal insulating layers 152a may be connected to each other in a predetermined unit between the contact plugs 170 adjacent to each other. For example, in FIG. 4A, a unit of the first horizontal insulating layers 152a may extend around four (4) adjacent contact plugs 170 in a cross-sectional view.

Referring to FIG. 4B, in a semiconductor device 100b, a first horizontal insulating layer 152b may be disposed throughout the second region R2. In the example embodiment, the first horizontal insulating layer 152b may be on (e.g., cover) upper surfaces of protrusions 170P (see FIG. 3A) of contact plugs 170, and also upper surfaces of dummy vertical structures DH.

As in the example embodiments in FIGS. 4A and 4B, the first horizontal insulating layers 152a and 152b may be disposed in various sizes in the second region R2 in a range in which the layers cover or overlap the upper surfaces of the protrusions 170P of the contact plugs 170.

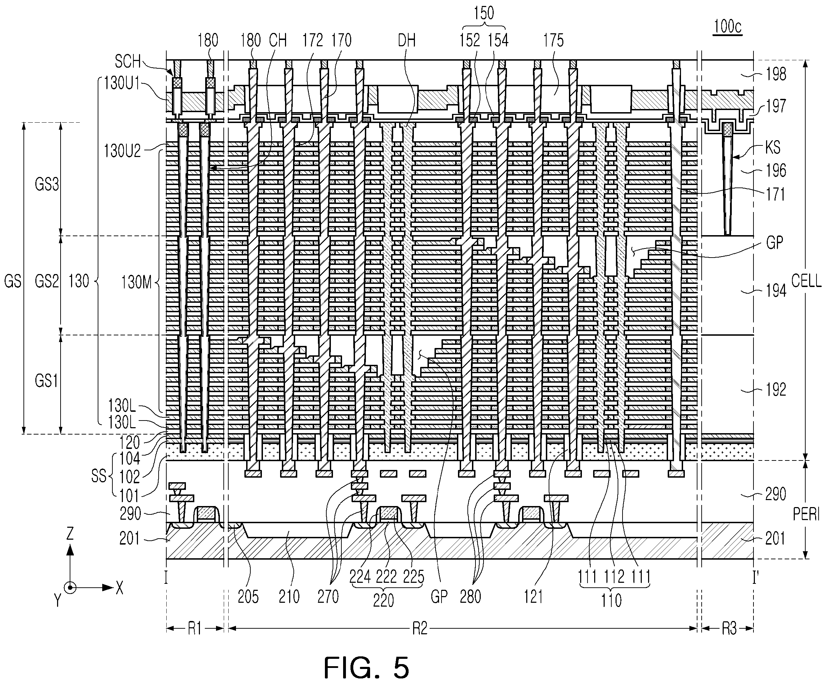

FIG. 5 is a cross-sectional view illustrating a semiconductor device according to example embodiments.

Referring to FIG. 5, a memory cell region CELL of a semiconductor device 100c may further include a through via 171 disposed in a second region R2. The through via 171 may be disposed in a form similar to that of the contact plugs 170. However, differently from the contact plugs 170, the through via 171 may extend in (e.g., penetrate) the entire gate electrodes 130 forming the gate structure GS in a region other than the gate pad region GP. Accordingly, the through via 171 need not be electrically and physically connected to the gate electrode 130, and may be (electrically) connected to a circuit interconnection line 280 of a peripheral circuit region PERI. For example, the through via 171 may be spaced apart (e.g., electrically separated) from the gate electrode 130. Similarly to the contact plugs 170, the through via 171 may also penetrate the first and second horizontal insulating layers 152 and 154, and the first horizontal insulating layer 152 may be on (e.g., cover or overlap) an upper surface of the protrusion of the through via 171 and may extend around (e.g., surround) a portion of a side surface of the through via 171.

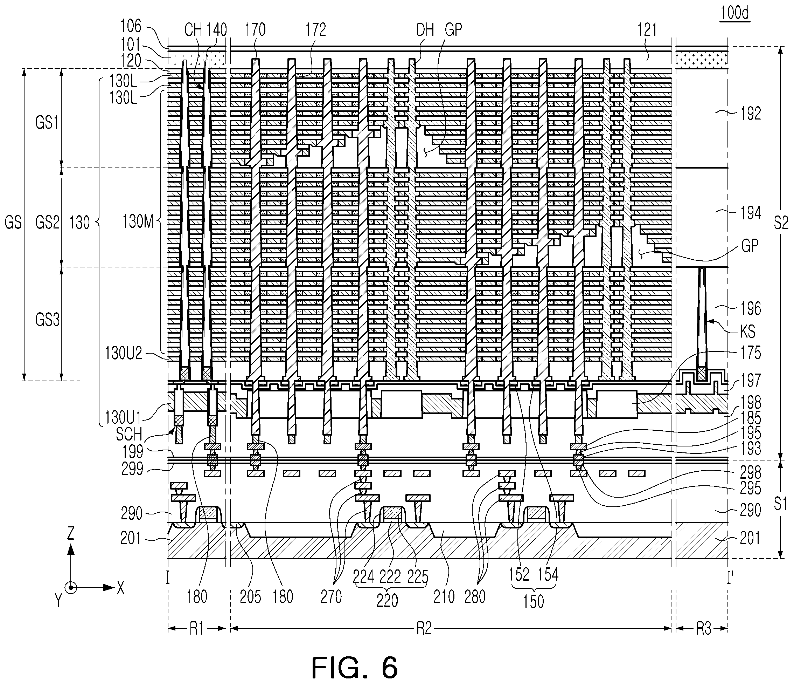

FIG. 6 is a cross-sectional view illustrating a semiconductor device according to example embodiments, illustrating a region corresponding to FIG. 2A.

Referring to FIG. 6, a semiconductor device 100d may include a first semiconductor structure S1 and a second semiconductor structure S2 bonded to each other by a wafer bonding method.

As for the first semiconductor structure S 1, the description of the peripheral circuit region PERI described above with reference to FIG. 2A may be applied. However, the first semiconductor structure S1 may further include first bonding vias 295, first bonding metal layers 298, and a first bonding insulating layer 299, which may be a bonding structure. The first bonding vias 295 may be disposed on an uppermost portion of the circuit interconnection lines 280 and may be (electrically) connected to the circuit interconnection lines 280. At least a portion of the first bonding metal layers 298 may be (electrically) connected to the first bonding vias 295 on the first bonding vias 295. The first bonding metal layers 298 may be (electrically) connected to the second bonding metal layers 193 of the second semiconductor structure S2. The first bonding metal layers 298, together with second bonding metal layers 193, may provide an electrical connection path by bonding between the first semiconductor structure S1 and the second semiconductor structure S2. A portion of the first bonding metal layers 298 need not be (electrically) connected to the circuit interconnection lines 280 and may be disposed only for bonding. The first bonding vias 295 and the first bonding metal layers 298 may include a conductive material, for example, copper (Cu). The first bonding insulating layer 299 may be disposed on circumferences of the first bonding metal layers 298. For example, the first bonding insulating layer 299 may extend around the first bonding metal layer 298. The first bonding insulating layer 299 may also function as a diffusion barrier of the first bonding metal layers 298 and may include, for example, SiN, SiON, SiCN, SiOC, SiOCN, and/or SiO.

As for the second semiconductor structure S2, the description for the memory cell region CELL described above with reference to FIGS. 1 to 3D may be applied unless otherwise indicated. The second semiconductor structure S2 may further include cell interconnection lines 185 as an interconnection structure, and may further include second bonding vias 195, second bonding metal layers 193, and a second bonding insulating layer 199 as a bonding structure. The second semiconductor structure S2 may further include a passivation layer 106 on (e.g., covering) an upper surface of the plate layer 101.

The cell interconnection lines 185 may be electrically connected to studs 180. However, in example embodiments, the number of layers and the arrangement forms of the contact plugs and the interconnection lines included in the interconnection structure may be varied. The cell interconnection lines 185 may be formed of a conductive material and may include, for example, tungsten (W), aluminum (Al), and/or copper (Cu).

The second bonding vias 195 and the second bonding metal layers 193 may be disposed below a lowermost portion of the cell interconnection lines 185. The second bonding vias 195 may (electrically) connect the cell interconnection lines 185 to the second bonding metal layers 193, and the second bonding metal layers 193 may be bonded to the first bonding metal layers 298 of the first semiconductor structure S1. The second bonding insulating layer 199 may be bonded and connected to the first bonding insulating layer 299 of the first semiconductor structure S1. The second bonding vias 195 and the second bonding metal layers 193 may include a conductive material, for example, copper (Cu). The second bonding insulating layer 199 may include, for example, SiO, SiN, SiCN, SiOC, SiON, and/or SiOCN.

The first and second semiconductor structures S1 and S2 may be bonded to each other by bonding between the first bonding metal layers 298 and the second bonding metal layers 193 and bonding between the first bonding insulating layer 299 and the second bonding insulating layer 199. The bonding between the first bonding metal layers 298 and the second bonding metal layers 193 may be, for example, copper (Cu)-to-copper (Cu) bonding, and the bonding between the first bonding insulating layer 299 and the second bonding insulating layer 199 may be, for example, dielectric-to-dielectric bonding such as SiCN-to-SiCN bonding. The first and second semiconductor structures S1 and S2 may be bonded to each other by hybrid bonding including copper (Cu)-to-copper (Cu) bonding and dielectric-to-dielectric bonding.

In the example embodiment, the second semiconductor structure S2 does not include the first and second horizontal conductive layers 102 and 104 (see FIG. 2A). The channel structures CH may be directly connected to the plate layer 101 while the first channel layers 140 are exposed through an upper end of the channel structures CH. However, the electrical connection form of the channel structures CH and the common source line (e.g., the first and second horizontal conductive layers 102 and 104) may be varied in example embodiments, and the channel structures CH and the source structures SS may have the structure as in the example embodiment in FIG. 2A.

The passivation layer 106 may be disposed on an upper surface of the plate layer 101 and may protect the semiconductor device 100d. The passivation layer 106 may include an insulating material, for example, silicon oxide, silicon nitride, and/or silicon carbide. The substrate insulating layer 121 may be disposed widely in the second region R2 to be on (e.g., cover) an upper end of the contact plugs 170. However, in example embodiments, the arrangement of the substrate insulating layer 121 may be varied in the range in which the contact plugs 170 is electrically isolated from the plate layer 101.

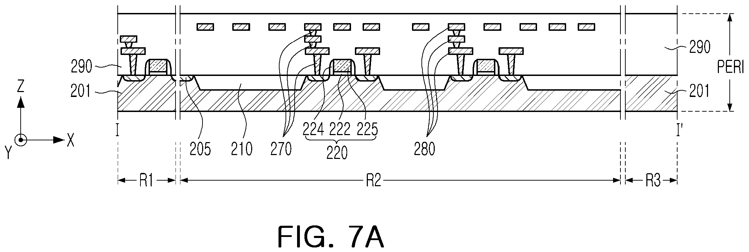

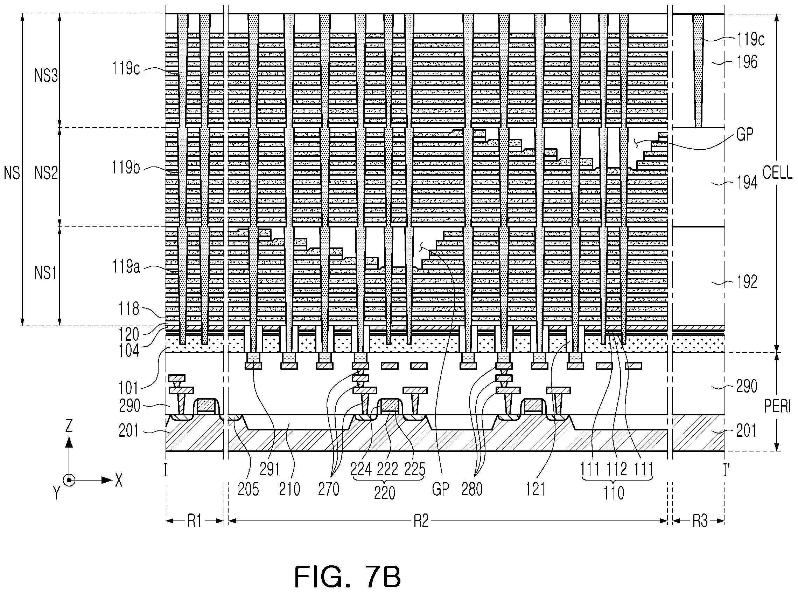

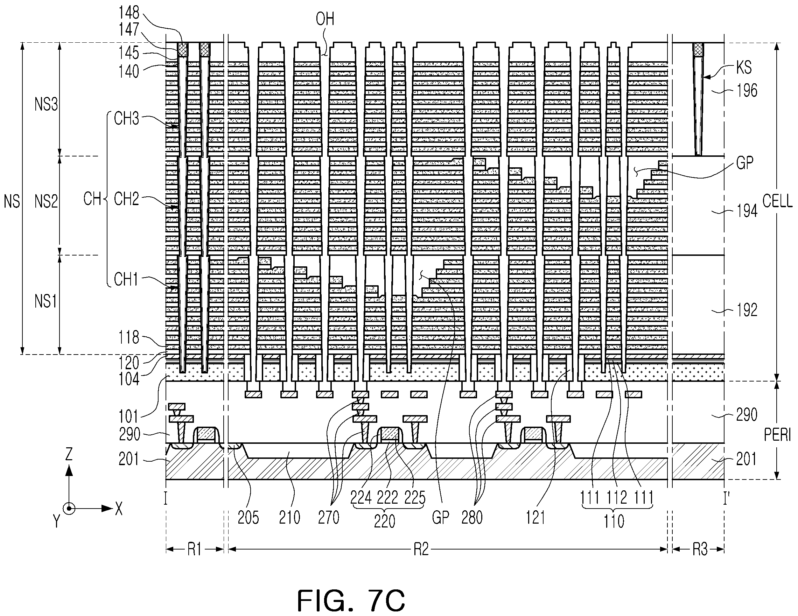

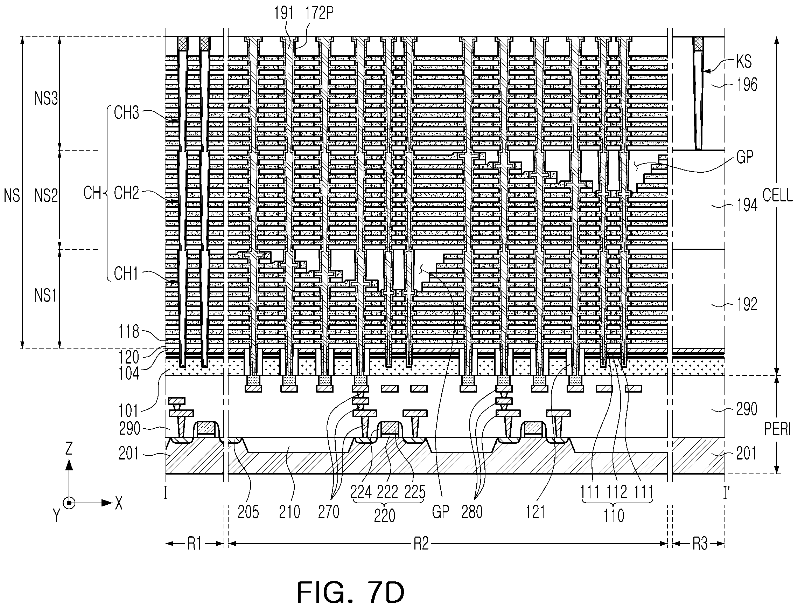

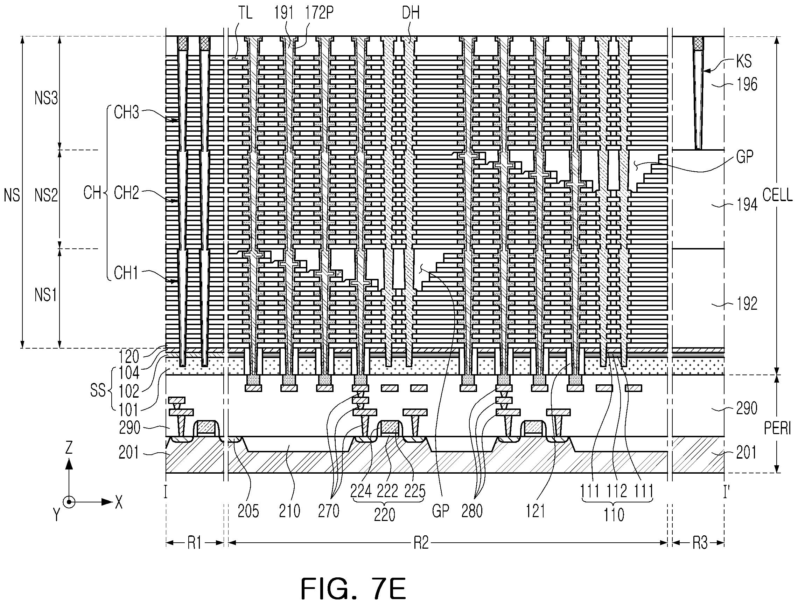

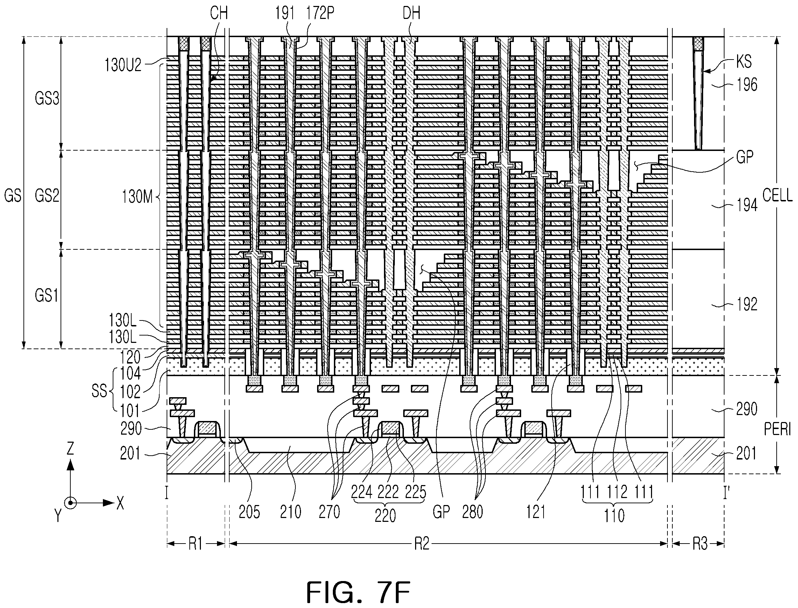

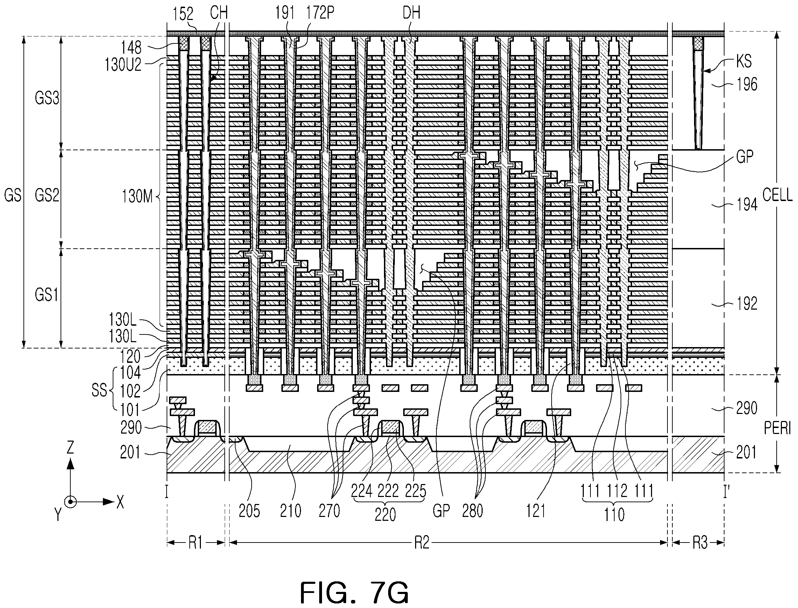

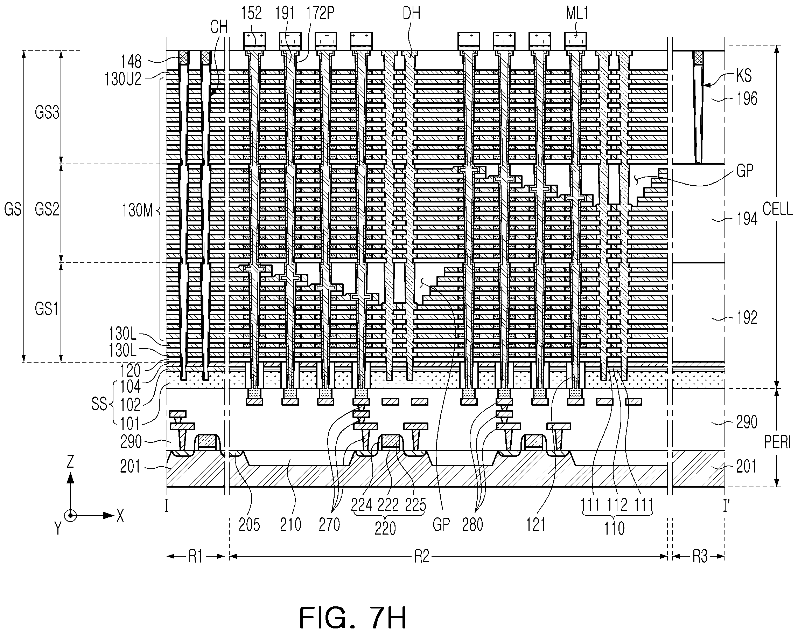

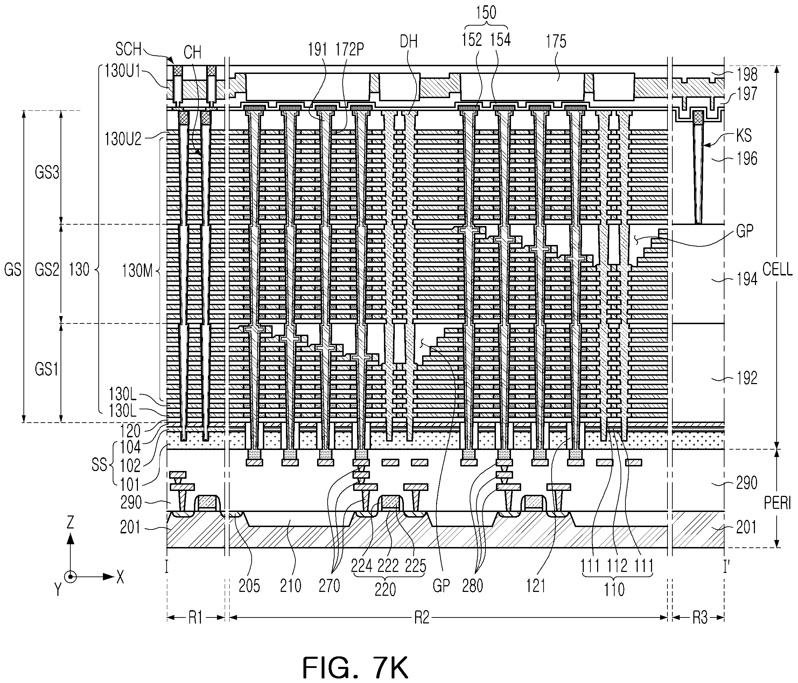

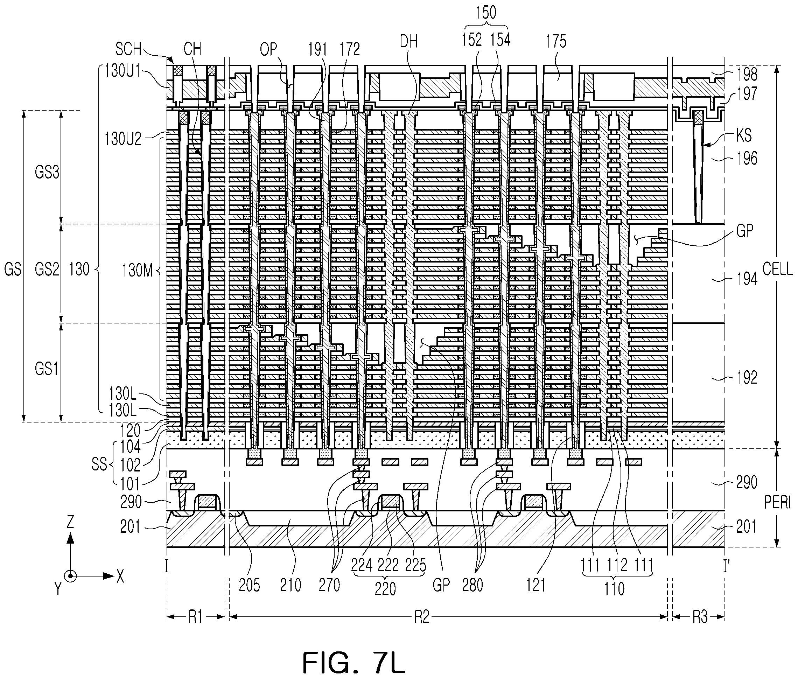

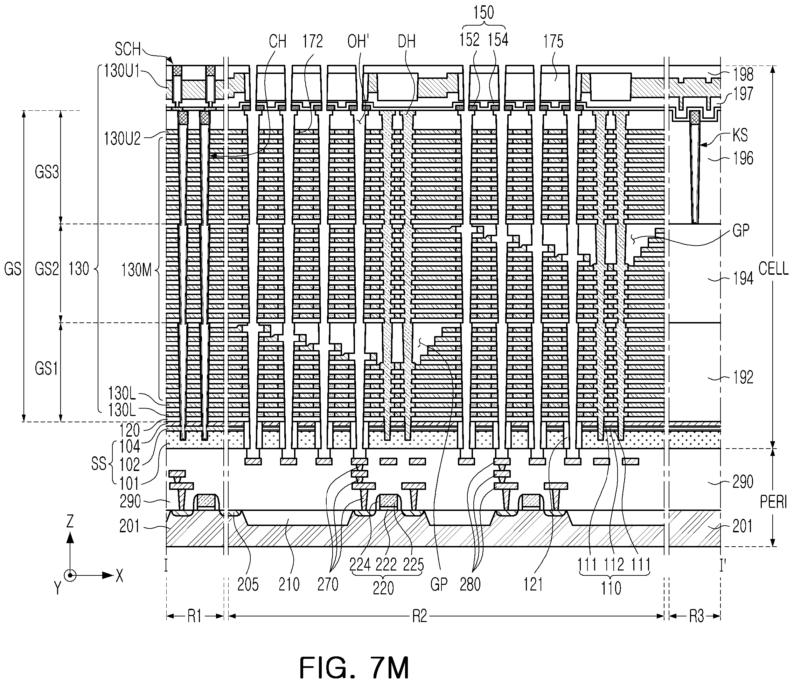

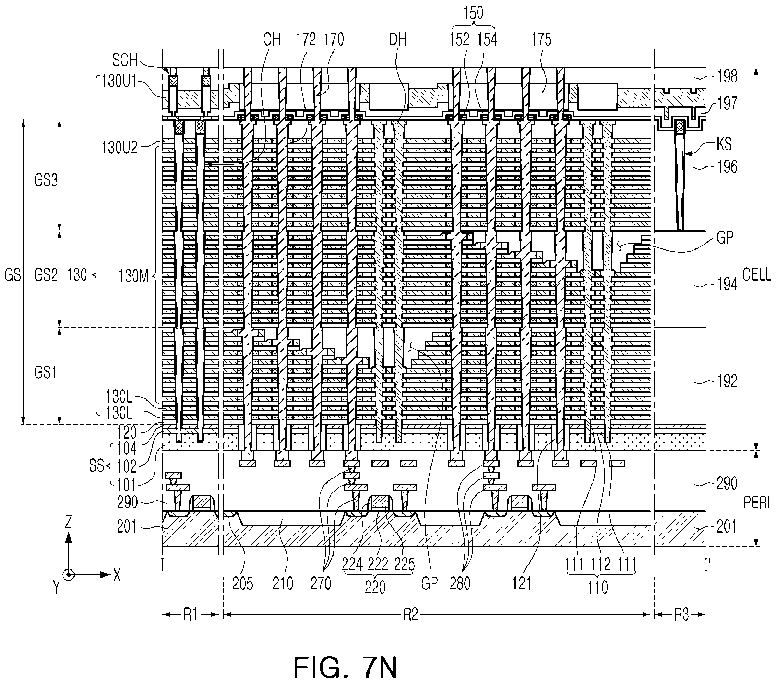

FIGS. 7A, 7B, 7C, 7D, 7E, 7F, 7G, 7H, 7I, 7J, 7K, 7L, 7M, and 7N are cross-sectional views illustrating a method of manufacturing a semiconductor device according to example embodiments, corresponding to FIG. 2A.

Referring to FIG. 7A, circuit devices 220, a circuit interconnection structure (e.g., the circuit contact plugs 270 and the circuit interconnection lines 280), and a peripheral region insulating layer 290 forming a peripheral circuit region PERI may be formed on a substrate 201.

First, the device isolation layers 210 may be formed in the substrate 201, and the circuit gate dielectric layer 222 and the circuit gate electrode 225 may be formed in order on the substrate 201. The device isolation layers 210 may be formed, for example, by a shallow trench isolation (STI) process. The circuit gate dielectric layer 222 and the circuit gate electrode 225 may be formed using atomic layer deposition (ALD) or chemical vapor deposition (CVD). The circuit gate dielectric layer 222 may include (e.g., may be formed of) silicon oxide, and the circuit gate electrode 225 may include (e.g., may be formed of) polycrystalline silicon and/or a metal silicide layer, but an example embodiment thereof is not limited thereto. Thereafter, a spacer layer 224 and impurity regions 205 may be formed on both sidewalls (e.g., sidewalls opposite to each other in the X-direction) of the circuit gate dielectric layer 222 and the circuit gate electrode 225. In example embodiments, the spacer layer 224 may include a plurality of layers. The impurity regions 205 may be formed by performing an ion implantation process.

Circuit contact plugs 270 of the circuit interconnection structures may be formed by partially forming the peripheral region insulating layer 290, etching and removing a portion thereof, and filling a conductive material. Circuit interconnection lines 280 may be formed, for example, by depositing a conductive material and patterning the material.

The peripheral region insulating layer 290 may include a plurality of insulating layers. The peripheral region insulating layer 290 may become a portion in each of processes of forming the circuit interconnection structure. Accordingly, the peripheral circuit region PERI may be formed.

Referring to FIG. 7B, a plate layer 101, a source insulating layer 110, a second horizontal conductive layer 104, and a substrate insulating layer 121 may be formed on the peripheral circuit region PERI, and the mold structure NS and the first, second, and third vertical sacrificial layers 119a, 119b, and 119c may be formed.

The plate layer 101 may be formed on the peripheral region insulating layer 290. The plate layer 101 may include (e.g., may be formed of), for example, polycrystalline silicon and may be formed by a CVD process. The polycrystalline silicon forming the plate layer 101 may include impurities.

When the plate layer 101 is formed, landing pads 291 may be formed on an uppermost portion of the circuit interconnection lines 280. The landing pads 291 may be formed in a region in which a lower end of the contact plugs 170 (see FIG. 2A) is disposed. First, before the plate layer 101 is formed, openings may be formed by partially removing the peripheral region insulating layer 290 on the uppermost portion of the circuit interconnection lines 280. When the plate layer 101 is formed, the openings may be filled with a material forming the plate layer 101, thereby forming the landing pads 291. The openings may be formed, for example, together with a ground via to connect the plate layer 101 to the circuit interconnection structure (e.g., the circuit contact plugs 270 and the circuit interconnection lines 280).

The first and second source insulating layers 111 and 112 included in the source insulating layer 110 may be alternately stacked on the plate layer 101. A portion of the source insulating layer 110 may be replaced with the first horizontal conductive layer 102 in FIG. 2A through a subsequent process. The first source insulating layer 111 may include a material different from that of the second source insulating layer 112. For example, the first source insulating layers 111 may include (e.g., may be formed of) the same material as that of the interlayer insulating layers 120, and the second source insulating layer 112 may include (e.g., may be formed of) the same material as that of the sacrificial insulating layers 118, which will be described later. The source insulating layer 110 may be removed from a portion of regions, for example, from a portion of the second region R2 through a patterning process.

The second horizontal conductive layer 104 may be formed on the source insulating layer 110 and may be in contact with the plate layer 101 in a region from which the source insulating layer 110 has been removed.

The substrate insulating layer 121 may be formed to penetrate the plate layer 101 in a portion of regions including the region in which the contact plugs 170 may be disposed. The substrate insulating layer 121 may be formed by removing (at least) a portion of the plate layer 101, the source insulating layer 110, and the second horizontal conductive layer 104, and filling an insulating material. After filling the insulating material, a planarization process may be further performed using a chemical mechanical polishing (CMP) process. Accordingly, an upper surface of the substrate insulating layer 121 may be substantially coplanar with an upper surface of the second horizontal conductive layer 104.

Thereafter, the first mold structure NS1 may have sacrificial insulating layers 118 and interlayer insulating layers 120 alternately stacked on the second horizontal conductive layer 104 and the substrate insulating layer 121. The first mold structure NS1 may be on a level on which the first stack structure GS1 (see FIG. 2A) is disposed.

At least a portion of the sacrificial insulating layers 118 may be replaced with the gate electrodes 130 (see FIG. 2A) through a subsequent process. The sacrificial insulating layers 118 may include (e.g., may be formed of) a material different from the interlayer insulating layers 120, and may include (e.g., may be formed of) a material etched with etch selectivity under specific etching conditions with respect to the interlayer insulating layers 120. For example, the interlayer insulating layer 120 may be formed of silicon oxide or silicon nitride, and the sacrificial insulating layers 118 may be formed of a material different from the interlayer insulating layer 120 selected from silicon, silicon oxide, silicon carbide, and silicon nitride. In example embodiments, the numbers of the interlayer insulating layers 120 and the sacrificial insulating layers 118 and thicknesses thereof may be varied from the illustrated examples.

The gate pad regions GP may be formed by repeatedly performing a photolithography process and an etching process for the sacrificial insulating layers 118 and the interlayer insulating layers 120. The gate pad regions GP may be formed in the second region R2, and the upper portion of (e.g., an upper one of) the sacrificial insulating layers 118 may be formed to include a region extending (in a horizontal direction) shorter than the lower portion of (e.g., a lower one of) the sacrificial insulating layers 118. In the gate pad regions GP, an asymmetrical step structure may be formed such that upper surfaces and ends of the plurality of sacrificial insulating layers 118 may be upwardly exposed. By further forming the sacrificial insulating layers 118 on the step structure of the gate pad regions GP, the sacrificial insulating layers 118 disposed in an uppermost portion of each region may have a relatively thick thickness. For example, an end portion of a sacrificial insulating layer 118 in the gate pad region GP may be thicker than other portions of the sacrificial insulating layer 118.

Thereafter, the first cell region insulating layer 192 on (e.g., covering) the first mold structure NS1 may be formed. The first vertical sacrificial layers 119a may be formed in positions corresponding to the first channel structures CH, the contact plugs 170, and the dummy vertical structures DH in FIG. 2A. The first vertical sacrificial layers 119a may be formed by forming holes to extend in (e.g., penetrate) the first mold structure NS1, depositing a sacrificial layer material on (in) the holes, and performing a planarization process. The first vertical sacrificial layers 119a may include, for example, carbon and/or a carbon-based material, but an example embodiment thereof is not limited thereto.

The second mold structure NS2, the second vertical sacrificial layers 119b, the second cell region insulating layer 194, the third mold structure NS3, the third vertical sacrificial layers 119c, and the third cell region insulating layer 196 may be formed on the first mold structure NS1 in the (substantially) same manner as in the process of forming each of the first mold structure NS1 and the first vertical sacrificial layers 119a. The second vertical sacrificial layers 119b may be connected to the first vertical sacrificial layers 119a, and the third vertical sacrificial layers 119c may be connected to the second vertical sacrificial layers 119b. In this process, the first, second, and third vertical sacrificial layers 119a, 119b, and 119c formed in the second region R2 may have a width similar to (or the same as) a width of those in the first region R1, and may have a width smaller than a width of the contact plugs 170 and a width of the dummy vertical structures DH. In the third region R3, the sacrificial insulating layers 118 need not be formed and the third vertical sacrificial layer 119c may be formed. For example, the first and second vertical sacrificial layers 119a and 119b may be omitted in the third region R3.

Referring to FIG. 7C, the first channel structures CH penetrating the mold structure NS may be formed, and the first contact holes OH may be formed.

First, a mask layer exposing only the first region R1 may be formed. The first channel structures CH may be formed by forming lower channel holes by removing the first, second, and third vertical sacrificial layers 119a, 119b, and 119c in the first region R1, and depositing at least a portion of the first gate dielectric layer 145, the first channel layer 140, the first channel filling insulating layer 147 and the first channel pad 148 in the lower channel holes in order. In the third region R3, the third vertical sacrificial layer 119c may be removed, and the align key structure KS may be formed with the first channel structures CH.

The first gate dielectric layer 145 may be formed to have a uniform thickness using an ALD or CVD process. In this process, the entirety or a portion of the first gate dielectric layer 145 may be formed, and a portion extending perpendicular to the plate layer 101 along the first channel structures CH may be formed in this process. The first channel layer 140 may be formed on the first gate dielectric layer 145 in the lower channel holes. The first channel filling insulating layer 147 may be formed to fill the lower channel holes and may include (e.g., may be) an insulating material. The first channel pad 148 may include (e.g., may be formed of) a conductive material, for example, polycrystalline silicon.

The first contact holes OH may be formed by selectively removing the first, second, and third vertical sacrificial layers 119a, 119b, and 119c from the second region R2 and further removing the exposed landing pads 291.

First, in the second region R2, a mask layer exposing the first, second, and third vertical sacrificial layers 119a, 119b, and 119c may be formed, and the first, second, and third vertical sacrificial layers 119a, 119b, and 119c exposed through the mask layer may be selectively removed. When the mask layer is formed to have openings greater than upper surfaces of the third vertical sacrificial layers 119c, the first contact holes OH may have an enlarged width on upper ends (of the third vertical sacrificial layers 119c) as illustrated in FIG. 7C. The circuit interconnection lines 280 may be exposed through lower surfaces (e.g., bottom surfaces) of the first contact holes OH. In some example embodiments, the landing pads 291 are not removed in this process and may be removed in a subsequent process.

Referring to FIG. 7D, after the first contact holes OH are enlarged, preliminary contact insulating layers 172P and vertical sacrificial layers 191 may be formed in the first contact holes OH.

First, the first contact holes OH may be enlarged by removing a portion of the sacrificial insulating layers 118 and the interlayer insulating layers 120 exposed through the first contact holes OH. During the above process, the sacrificial insulating layers 118 may be removed relatively longer in the horizontal direction than the interlayer insulating layers 120. Thereafter, the sacrificial insulating layers 118 may be further removed around the first contact holes OH, thereby forming contact tunnel portions. The contact tunnel portions may have a relatively short (shorter) length in (at) an uppermost one of the sacrificial insulating layers 118, and may have a relatively long (longer) length in (at) the sacrificial insulating layers 118 therebelow.

By depositing an insulating material in the first contact holes OH and the contact tunnel portions, preliminary contact insulating layers 172P may be formed. The preliminary contact insulating layers 172P may be formed on a sidewall of the first contact holes OH and may fill the contact tunnel portions. In (at) the uppermost one of the sacrificial insulating layers 118, the preliminary contact insulating layers 172P need not completely fill the contact tunnel portions.

The vertical sacrificial layers 191 may fill the first contact holes OH and contact tunnel portions of the uppermost one of the sacrificial insulating layers 118. The vertical sacrificial layers 191 may include a material different from that of the preliminary contact insulating layers 172P, for example, carbon (C).

Referring to FIG. 7E, dummy vertical structures DH may be formed and sacrificial insulating layers 118 may be removed.

First, a mask layer exposing the preliminary contact insulating layers 172P and the vertical sacrificial layers 191 may be formed in a position corresponding to the dummy vertical structures DH. After the vertical sacrificial layers 191 exposed through the mask layer is removed, dummy vertical structures DH may be formed by depositing an insulating material. For example, the insulating material may include the same material as that of the preliminary contact insulating layers 172P. The remaining preliminary contact insulating layers 172P may form a portion of the dummy vertical structures DH.

Thereafter, openings extending to the plate layer 101 may be formed by penetrating the sacrificial insulating layers 118 and the interlayer insulating layers 120 in a position of the first isolation regions MS (see FIG. 1). Thereafter, by performing an etch-back process while sacrificial spacer layers are formed in the openings, the source insulating layer 110 may be selectively removed, and a portion of the exposed first gate dielectric layer 145 may also be removed. The first horizontal conductive layer 102 may be formed by depositing a conductive material in a region in which the source insulating layer 110 has been removed, and the sacrificial spacer layers may be removed from the openings. Through this process, the first horizontal conductive layer 102 may be formed in the first region R1.

Thereafter, the sacrificial insulating layers 118 may be selectively removed with respect to the interlayer insulating layers 120, the second horizontal conductive layer 104, the first channel structures CH, the preliminary contact insulating layers 172P, and the dummy vertical structures DH, for example, using wet etching. Accordingly, gate tunnel portions TL may be formed in the region from which the sacrificial insulating layers 118 have been removed.

Referring to FIG. 7F, gate electrodes 130 may be formed in the gate tunnel portions TL.

The gate electrodes 130 may be formed by depositing a conductive material on the gate tunnel portions TL. The conductive material may include, for example, metal, polycrystalline silicon, and/or metal silicide material. In some example embodiments, a portion of the first gate dielectric layer 145 may be formed preferentially before the gate electrodes 130 is formed. Accordingly, the gate structure GS including the first, second, and third stack structures GS1, GS2, and GS3 may be formed.

After the gate electrodes 130 is formed, first isolation regions MS may be formed by depositing an insulating material in the openings corresponding to the first isolation regions MS (see FIG. 2B).

Referring to FIG. 7G, the first horizontal insulating layer 152 may be formed on the first channel structures CH, preliminary contact insulating layers 172P, and vertical sacrificial layers 191.

First, to perform the process, a planarization process may be performed to remove the mask layer formed on the first channel structures CH. The planarization process may be, for example, a CMP process, and may be performed using the first channel pads 148 of the first channel structures CH as a stop layer.

The first horizontal insulating layer 152 may be formed throughout the first, second, and third regions R1, R2, and R3. The first horizontal insulating layer 152 may extend horizontally by covering or overlapping upper surfaces of the first channel structures CH, upper surfaces of the dummy vertical structures DH, and an upper surface of the align key structure KS, and covering or overlapping upper surfaces of the preliminary contact insulating layers 172P and the vertical sacrificial layers 191.

Referring to FIG. 7H, the first horizontal insulating layer 152 may be patterned.

A patterning process may be performed using the first mask layer ML1 such that the first horizontal insulating layers 152 may remain only on upper surfaces of the preliminary contact insulating layers 172P and the vertical sacrificial layers 191. Accordingly, the first horizontal insulating layer 152 may be completely removed from the first region R1 and the third region R3, and the first horizontal insulating layer 152 may also be removed from a portion of the second region R2. The upper surfaces of the preliminary contact insulating layers 172P and the vertical sacrificial layers 191 may be completely covered or overlapped by the first horizontal insulating layers 152. For example, the first horizontal insulating layer 152 may only overlap the preliminary contact insulating layers 172P and the vertical sacrificial layers 191 in the Z-direction. The first mask layer ML1 may include, for example, a photoresist layer.

During an etching process to remove a portion of the first horizontal insulating layer 152, the first horizontal insulating layer 152 may be selectively removed with respect to the third cell region insulating layer 196. Therefore, the loss of the third cell region insulating layer 196 surrounding upper ends of the first channel structures CH may be reduced (e.g., prevented), such that the first channel structures CH may be not damaged.

The example embodiments in FIGS. 4A and 4B may be manufactured by varying the region in which the first horizontal insulating layer 152 is removed in this process.

Referring to FIG. 7I, the first mask layer ML1 may be removed, the second mask layer ML2 may be formed, and a recess region RC may be formed in the third region R3.

The first mask layer ML1 may be removed, for example, by an ashing and strip process. The ashing process may be performed using, for example, oxygen plasma. During the ashing process, the exposed first channel pads 148 may be partially oxidized such that upper end insulating layers 149 may be formed on the first channel pads 148 of the first channel structures CH and the align key structure KS.

Thereafter, a portion of the third region R3 may be exposed by forming the second mask layer ML2, a portion of the third cell region insulating layer 196 may be selectively removed. The second mask layer ML2 may include, for example, a photoresist layer. Accordingly, a recess region RC exposing the upper region of the align key structure KS may be formed, and the upper end insulating layer 149 of the align key structure KS may be removed.

Referring to FIG. 7J, the second mask layer ML2 may be removed, and the second horizontal insulating layer 154, the fourth cell region insulating layer 197, and the first upper gate electrode 130U1 may be formed in order.

The second mask layer ML2 may be removed, for example, by an ashing and strip process. During the ashing process, the preliminary contact insulating layers 172P and the vertical sacrificial layers 191 may be covered or overlapped by the first horizontal insulating layers 152 and need not be exposed. Therefore, even when the vertical sacrificial layers 191 include carbon (C), the vertical sacrificial layers 191 need not be removed or damaged during the above process.

The second horizontal insulating layer 154 may cover or overlap the first horizontal insulating layers 152 and may conformally extend. The fourth cell region insulating layer 197 and the first upper gate electrode 130U1 may be formed in order on the second horizontal insulating layer 154. The first upper gate electrode 130U1 may include a material different from that of the other gate electrodes 130, but an example embodiment thereof is not limited thereto. For example, the first upper gate electrode 130U1 may include polycrystalline silicon.

Referring to FIG. 7K, isolation insulating layers 175 and second channel structures SCH penetrating the first upper gate electrode 130U1 may be formed.

The isolation insulating layers 175 may be formed to penetrate the first upper gate electrode 130U1. The isolation insulating layers 175 may be formed together with the second isolation regions US in FIGS. 1 and 2B. For example, the first and second openings penetrating the first upper gate electrode 130U1 may be formed. The first openings may correspond to a position in which the second isolation regions US, and the second openings may correspond to a position in which the isolation insulating layers 175 are formed. An insulating material may be deposited on the first and second openings, and second isolation regions US may be formed by filling the first openings having a relatively small (e.g., smaller) size. The second openings having a relatively large (e.g., larger) size may be completely filled during the process of depositing the insulating material forming the fifth cell region insulating layer 198, thereby forming the isolation insulating layers 175.

Thereafter, to form the second channel structure SCH, an upper channel hole extending in (e.g., penetrating) the first upper gate electrode 130U1 may be formed. Referring to FIG. 3C together, a second gate dielectric layer 165 and a sacrificial layer may be formed in order in the upper channel hole. Thereafter, a lower hole penetrating the second gate dielectric layer 165, the sacrificial layer, and the second horizontal insulating layer 154 may be formed on the lower surface (e.g., the bottom surface) of the upper channel hole, and a portion of the second horizontal insulating layer 154 exposed through the lower hole may be removed. When the second horizontal insulating layer 154 is partially removed, damages to the first channel pad 148 may be prevented by the upper end insulating layer 149.

After the sacrificial layer is removed, a second channel layer 160, a second channel filling insulating layer 167, and a second channel pad 169 may be formed in order in the upper channel hole, thereby forming a second channel structure SCH. The material forming the second channel layer 160 may fill regions from which the second horizontal insulating layer 154 has been removed, thereby forming the connection pad portion 160P (see FIG. 3C). Each layer may be formed in (substantially) the same manner as in the process of forming the first channel structures CH. The second channel layer 160 may be electrically connected to the first channel structure CH through the connection pad portion 160P.

Referring to FIG. 7L, upper openings OP may be formed to expose vertical sacrificial layers 191.

The upper openings OP may be formed to penetrate the fifth cell region insulating layer 198, the isolation insulating layers 175, the second horizontal insulating layer 154, and the first horizontal insulating layers 152. The upper openings OP may be formed such that the vertical sacrificial layers 191 may be exposed at least through the lower surfaces (e.g., the bottom surfaces) of the upper openings OP. For example, upper portions of the vertical sacrificial layers 191 may be exposed by the upper openings OP.

Referring to FIG. 7M, the second contact holes OH' may be formed by removing the vertical sacrificial layers 191 exposed through the upper openings OP and (at least partially) removing the preliminary contact insulating layers 172P.

The vertical sacrificial layers 191 may be selectively removed with respect to the interlayer insulating layers 120 and the gate electrodes 130. A portion of the preliminary contact insulating layers 172P exposed after the vertical sacrificial layers 191 are removed may also be removed. In this case, the preliminary contact insulating layers 172P may be completely removed from the upper (e.g., uppermost) ones of the gate electrodes 130 corresponding to contact regions 130P (see FIG. 3B), and may remain therebelow to form the contact insulating layers 172. In contact regions 130P, when the first gate dielectric layer 145 is exposed after the preliminary contact insulating layers 172P are removed, the first gate dielectric layer 145 may also be removed to expose the side surfaces of the gate electrodes 130.

Referring to FIG. 7N, contact plugs 170 may be formed.

The contact plugs 170 may be formed by depositing a conductive material in the second contact holes OH'. The contact plugs 170 may be formed to have horizontal extension portions 170H (see FIG. 3B) horizontally enlarged in (at) the contact regions 130P and accordingly, the contact plugs 170 may be physically and electrically connected to the gate electrodes 130.

Thereafter, referring to FIG. 2A together, by forming the studs 180 (electrically) connected to upper ends of the contact plugs 170 and the second channel structures SCH, the semiconductor device 100 may be manufactured.

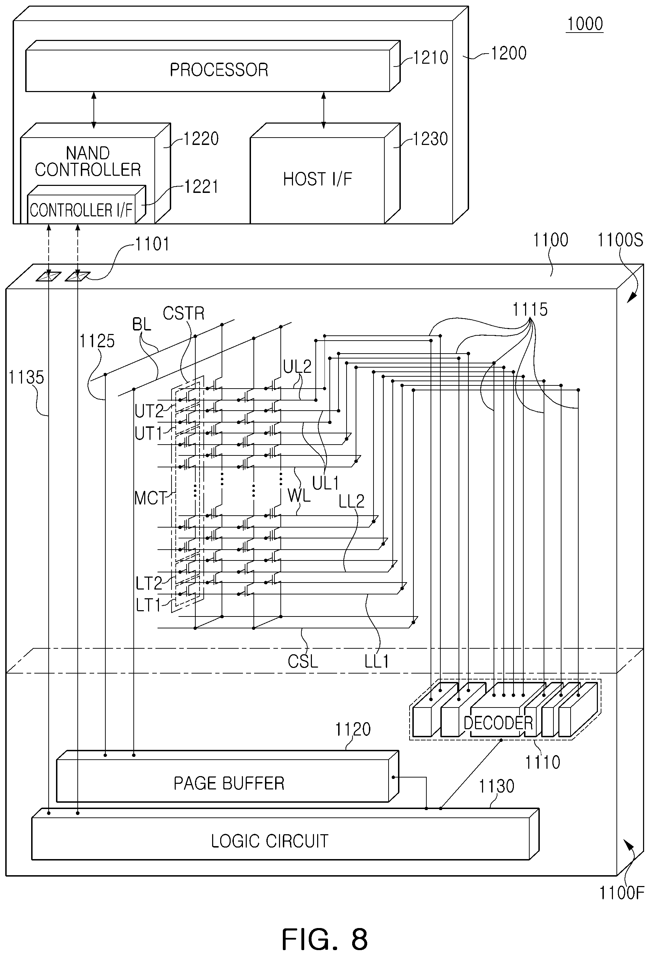

FIG. 8 is a view illustrating a data storage system including a semiconductor device according to an example embodiment.

Referring to FIG. 8, a data storage system 1000 may include a semiconductor device 1100 and a controller 1200 electrically connected to the semiconductor device 1100. The data storage system 1000 may be implemented as a storage device including one or a plurality of semiconductor devices 1100 or an electronic device including a storage device. For example, the data storage system 1000 may be implemented as a solid state drive device (SSD) including one or a plurality of semiconductor devices 1100, a universal serial bus (USB), a computing system, a medical device, or a communication device.

The semiconductor device 1100 may be implemented as a non-volatile memory device, such as, for example, the NAND flash memory device described in the aforementioned example embodiment with reference to FIGS. 1 to 6. The semiconductor device 1100 may include a first structure 1100F and a second structure 1100S on the first structure 1100F. In the example embodiments, the first structure 1100F may be disposed on the side of (e.g., adjacent) the second structure 1100S. The first structure 1100F may be implemented as a peripheral circuit structure including a decoder circuit 1110, a page buffer 1120, and a logic circuit 1130. The second structure 1100S may be implemented as a memory cell structure including a bitline BL, a common source line CSL, wordlines WL, first and second gate upper lines UL1 and UL2, first and second gate lower lines LL1 and LL2 and memory cell strings CSTR disposed between the bitline BL and the common source line CSL.

In the second structure 1100S, each of the memory cell strings CSTR may include lower transistors LT1 and LT2 adjacent to the common source line CSL, upper transistors UT1 and UT2 adjacent to the bitline BL, and a plurality of memory cell transistors MCT disposed between the lower transistors LT1 and LT2 and the upper transistors UT1 and UT2. The number of the lower transistors LT1 and LT2 and the number of the upper transistors UT1 and UT2 may be varied in the example embodiments.

In the example embodiments, the upper transistors UT1 and UT2 may include a string select transistor, and the lower transistors LT1 and LT2 may include a ground select transistor. The (first and second) gate lower lines LL1 and LL2 may be configured as gate electrodes of the lower transistors LT1 and LT2, respectively. The wordlines WL may be configured as gate electrodes of the memory cell transistors MCT, and the (first and second) gate upper lines UL1 and UL2 may be configured as gate electrodes of the upper transistors UT1 and UT2, respectively.

In the example embodiments, the lower transistors LT1 and LT2 may include a lower erase control transistor LT1 and a ground select transistor LT2 (electrically) connected to each other in series. The upper transistors UT1 and UT2 may include a string select transistor UT1 and an upper erase control transistor UT2 (electrically) connected to each other in series. At least one of the lower erase control transistor LT1 and the upper erase control transistor UT2 may be used in an erase operation for erasing data stored in the memory cell transistors MCT using a GIDL phenomenon.

The common source line CSL, the first and second gate lower lines LL1 and LL2, the wordlines WL, and the first and second gate upper lines UL1 and UL2 may be electrically connected to the decoder circuit 1110 through first connection interconnections 1115 extending between the first structure 1100F and the second structure 1100S. The bitlines BL may be electrically connected to the page buffer 1120 through second connection interconnections 1125 extending between the first structure 1100F and the second structure 1100S.

In the first structure 1100F, the decoder circuit 1110 and the page buffer 1120 may perform a control operation on at least one selected memory cell transistor among the plurality of memory cell transistors MCT. The decoder circuit 1110 and the page buffer 1120 may be controlled by the logic circuit 1130. The semiconductor device 1100 may communicate with the controller 1200 through the input/output pad 1101 electrically connected to the logic circuit 1130. The input/output pads 1101 may be electrically connected to the logic circuit 1130 through an input/output connection line 1135 extending between the first structure 1100F and the second structure 1100S.

The controller 1200 may include a processor 1210, a NAND controller 1220, and a host interface 1230. In the example embodiments, the data storage system 1000 may include a plurality of semiconductor devices 1100, and in this case, the controller 1200 may control the plurality of semiconductor devices 1100.

The processor 1210 may control overall operation of the data storage system 1000 including the controller 1200. The processor 1210 may operate according to a predetermined firmware, and may access the semiconductor device 1100 by controlling the NAND controller 1220. The NAND controller 1220 may include a controller interface 1221 processing communication with the semiconductor device 1100. Through the controller interface 1221, a control command for controlling the semiconductor device 1100, data to be written to the memory cell transistors MCT of the semiconductor device 1100, and data to be read from the memory cell transistors MCT of the semiconductor device 1100 may be transmitted. The host interface 1230 may provide a communication function between the data storage system 1000 and an external host. When a control command from an external host is received through the host interface 1230, the processor 1210 may control the semiconductor device 1100 in response to the control command.

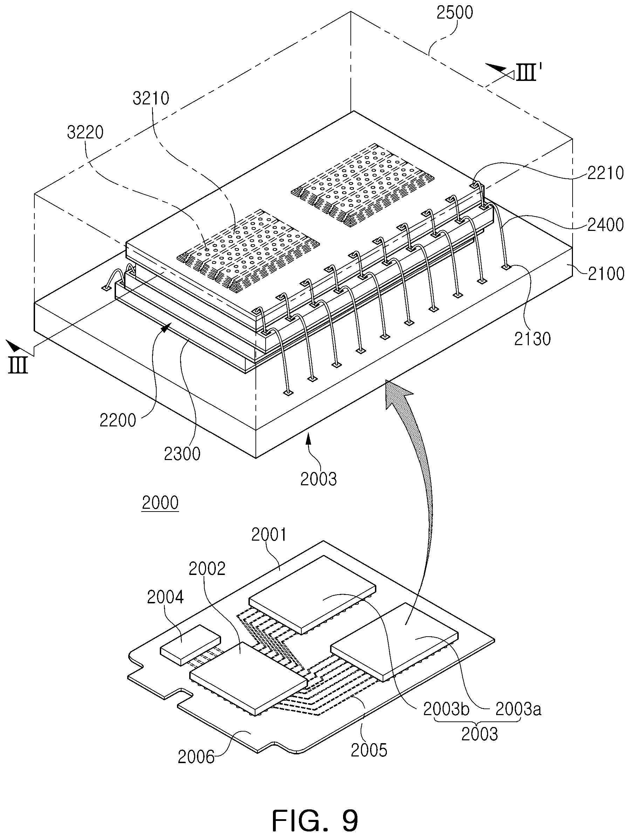

FIG. 9 is a perspective view illustrating a data storage system including a semiconductor device according to an example embodiment. As used hereinafter, the terms "external/outside configuration", "external/outside device", "external/outside power", "external/outside signal", or "outside" are intended to broadly refer to a device, circuit, block, module, power, and/or signal that resides externally (e.g., outside of a functional or physical boundary) with respect to a given circuit, block, module, system, or device.

Referring to FIG. 9, a data storage system 2000 in an example embodiment may include a main board 2001, a controller 2002 mounted on the main board 2001, one or more semiconductor packages 2003, and a DRAM 2004. The semiconductor package 2003 and the DRAM 2004 may be (electrically) connected to the controller 2002 by interconnection patterns 2005 formed on the main board 2001.

The main board 2001 may include a connector 2006 including a plurality of pins coupled to an external host. The number and arrangement of the plurality of pins in the connector 2006 may be varied depending on a communication interface between the data storage system 2000 and the external host. In the example embodiments, the data storage system 2000 may communicate with an external host according to one of interfaces from among universal serial bus (USB), peripheral component interconnect express (PCI-Express), serial advanced technology attachment (SATA), M-Phy for universal flash storage (UFS). In the example embodiments, the data storage system 2000 may operate by power supplied from an external host through the connector 2006. The data storage system 2000 may further include a power management integrated circuit (PMIC) for distributing power supplied from the external host to the controller 2002 and the semiconductor package 2003.

The controller 2002 may write data to or may read data from the semiconductor package 2003, and may improve an operating speed of the data storage system 2000.

The DRAM 2004 may be configured as a buffer memory for alleviating a difference in speeds between the semiconductor package 2003, which is a data storage space, and an external host. The DRAM 2004 included in the data storage system 2000 may operate as a cache memory, and may provide a space for temporarily storing data in a control operation for the semiconductor package 2003. When the data storage system 2000 includes the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may be configured as a semiconductor package including a plurality of semiconductor chips 2200. Each of the first and second semiconductor packages 2003a and 2003b may include a package substrate 2100, semiconductor chips 2200 on the package substrate 2100, adhesive layers 2300 disposed on lower surfaces of the semiconductor chips 2200, respectively, a connection structure 2400 electrically connecting the semiconductor chips 2200 to the package substrate 2100, and a molding layer 2500 on (e.g., covering) the semiconductor chips 2200 and the connection structure 2400 on the package substrate 2100.

The package substrate 2100 may be configured as a printed circuit board including package upper pads 2130. Each semiconductor chip 2200 may include an input/output pad 2210. The input/output pad 2210 may correspond to the input/output pad 1101 in FIG. 8. Each of the semiconductor chips 2200 may include gate stack structures 3210 and channel structures 3220. Each of the semiconductor chips 2200 may include the semiconductor device described in the aforementioned example embodiment with reference to FIGS. 1 to 6.

In the example embodiments, the connection structure 2400 may be configured as a bonding wire electrically connecting the input/output pad 2210 to the package upper pads 2130. Accordingly, in each of the first and second semiconductor packages 2003a and 2003b, the semiconductor chips 2200 may be electrically connected to each other by a bonding wire method, and may be electrically connected to the package upper pads 2130 of the package substrate 2100. In the example embodiments, in each of the first and second semiconductor packages 2003a and 2003b, the semiconductor chips 2200 may be electrically connected to each other by a connection structure including a through-electrode (TSV) instead of the connection structure 2400 of a bonding wire method.

In the example embodiments, the controller 2002 and the semiconductor chips 2200 may be included in a single package. In an example embodiment, the controller 2002 and the semiconductor chips 2200 may be mounted on an interposer substrate different from the main board 2001, and the controller 2002 and the semiconductor chips 2200 may be (electrically) connected to each other by interconnection formed on the interposer substrate.

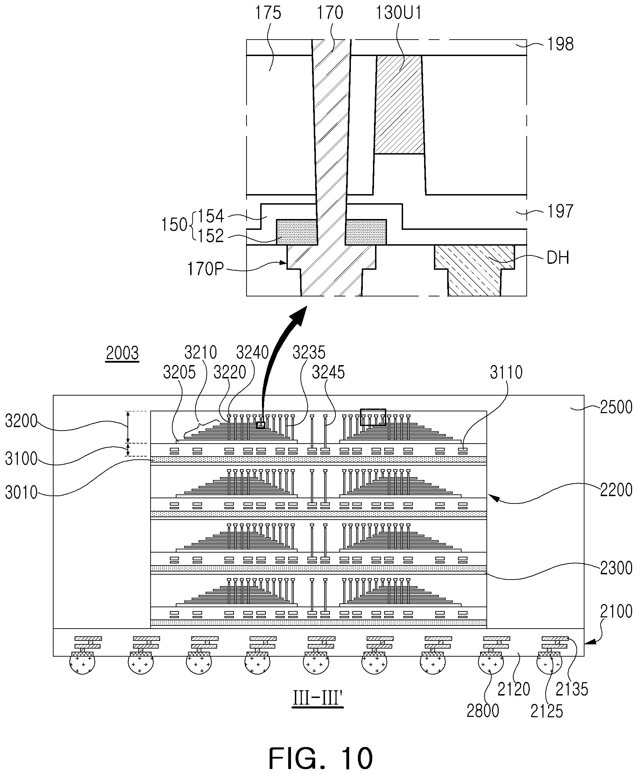

FIG. 10 is a cross-sectional view illustrating a semiconductor package according to an example embodiment, illustrating an example embodiment of the semiconductor package 2003 in FIG. 9 taken along line III-III'.

Referring to FIG. 10, in the semiconductor package 2003, the package substrate 2100 may be implemented as a printed circuit substrate. The package substrate 2100 may include a package substrate body portion 2120, package upper pads 2130 (see FIG. 9) disposed on an upper surface of the package substrate body portion 2120, lower pads 2125 disposed on the lower surface of the package substrate body portion 2120 or exposed through the lower surface, and internal interconnections 2135 electrically connecting the package upper pads 2130 to the lower pads 2125 in the package substrate body portion 2120. The lower pads 2125 may be (electrically) connected to the interconnection patterns 2005 of the main board 2001 of the data storage system 2000 as illustrated in FIG. 9 through conductive connection portions 2800.

Each of the semiconductor chips 2200 may include a semiconductor substrate 3010 and a first structure 3100 and a second structure 3200 stacked in order on the semiconductor substrate 3010. The first structure 3100 may include a peripheral circuit region including peripheral interconnections 3110. The second structure 3200 may include a common source line 3205, a gate stack structure 3210 on the common source line 3205, channel structures 3220 extending in (e.g., penetrating through) the gate stack structure 3210, bitlines 3240 electrically connected to the channel structures 3220, and contact plugs 3235 electrically connected to the wordlines WL (see FIG. 8) of the gate stack structure 3210. As described in the aforementioned example embodiment with reference to FIGS. 1 to 6, in each of the semiconductor chips 2200, the contact plug 170 may extend in (e.g., penetrate) the first and second horizontal insulating layers 152 and 154 in an upper region of the contact plug 170.

Each of the semiconductor chips 2200 may include a through-interconnection 3245 electrically connected to the peripheral interconnections 3110 of the first structure 3100 and extending into the second structure 3200. The through-interconnection 3245 may be disposed on an external side of the gate stack structure 3210 and may further be disposed to penetrate through the gate stack structure 3210. Each of the semiconductor chips 2200 may further include an input/output pad 2210 (see FIG. 9) electrically connected to the peripheral interconnections 3110 of the first structure 3100.

According to the aforementioned example embodiments, by preventing the vertical sacrificial layer from being exposed during the manufacturing process by disposing the first horizontal insulating layer surrounding a portion of side surfaces of the contact plugs, a semiconductor device having improved reliability and a data storage system including the same may be provided.

While the example embodiments have been illustrated and described above, it will be configured as apparent to those skilled in the art that modifications, variations, and combinations of the embodiments could be made without departing from the scope of the present disclosure as defined by the appended claims.

## Claims

1. A semiconductor device, comprising:
a first semiconductor structure including a substrate, circuit devices on the substrate, and circuit interconnection lines on the circuit devices; and
a second semiconductor structure on the first semiconductor structure and having first, second, and third regions,
wherein the second semiconductor structure includes:
a plate layer;
gate electrodes including a lower select gate electrode, memory gate electrodes, and an upper select gate electrode on the plate layer and spaced apart from each other in a first direction perpendicular to an upper surface of the plate layer;
first channel structures extending into the lower select gate electrode and the memory gate electrodes in the first direction, in the first region;
second channel structures extending into the upper select gate electrode and electrically connected to the first channel structures, respectively, in the first region;
a horizontal insulating layer extending in a second direction between the first channel structures and the second channel structures; and
contact plugs extending into the gate electrodes in the first direction, and electrically connecting the gate electrodes to the circuit interconnection lines, in the second region,
wherein the horizontal insulating layer has a first thickness in the first region and a second thickness greater than the first thickness in at least a portion of the second region,
wherein the second direction is parallel with the upper surface of the plate layer, and
wherein the second region is between the first region and the third region in the second direction.

2. The semiconductor device of claim 1, wherein an upper surface of the upper select gate electrode is a first distance from the upper surface of the plate layer in the first region and is a second distance from the upper surface of the plate layer at the at least a portion of the second region, and wherein the second distance is greater than the first distance.

3. The semiconductor device of claim 1 or 2, wherein the horizontal insulating layer includes a first horizontal insulating layer in the at least a portion of the second region and a second horizontal insulating layer in the first, second, and third regions, and wherein the second horizontal insulating layer is on the first horizontal insulating layer.

4. The semiconductor device of claim 3, wherein the contact plugs extend in the first and second horizontal insulating layers.

5. The semiconductor device of any one of claims 1 to 4, wherein the second thickness is greater than the first thickness by a range of 100 angstroms (Å) to 300 Å.

6. The semiconductor device of any one of claims 1 to 5, wherein the horizontal insulating layer include nitride.

7. The semiconductor device of any one of claims 1 to 6, wherein the second semiconductor structure further includes an align key structure in the third region and the align key structure has a structure corresponding to at least an upper region of the first channel structures.

8. The semiconductor device of claim 7, wherein the horizontal insulating layer has the first thickness in the third region.

9. The semiconductor device of claim 7 or 8, wherein the horizontal insulating layer is on an upper surface and a portion of a side surface of the align key structure.

10. The semiconductor device of claim 7, 8 or 9, wherein the third region is configured as a scribe lane region.

11. The semiconductor device of any one of claims 7 to 10, wherein each of the first channel structures includes a plurality of channel portions on the plate layer, and wherein the align key structure and an uppermost channel portion among the plurality of channel portions are at a same distance from the upper surface of the plate layer in the first direction.

12. The semiconductor device of any one of claims 1 to 11, wherein the second semiconductor structure further includes dummy vertical structures below the horizontal insulating layer, extending into the gate electrodes in the first direction, in the second region.

13. The semiconductor device of claim 12, wherein portions of the horizontal insulating layer have the first thickness on the dummy vertical structures.

14. The semiconductor device of any one of claims 1 to 13, wherein each of the contact plugs includes a vertical extension portion extending in the first direction, and a horizontal extension portion extending in the second direction from the vertical extension portion and in contact with one of the gate electrodes.

15. A data storage system, comprising:
the semiconductor device of any one of the preceding claims, the semiconductor device further including an input/output pad electrically connected to the circuit devices; and
a controller electrically connected to the semiconductor device through the input/output pad and configured to control the semiconductor device.
